# EUROPEAN PATENT APPLICATION

(11) **EP 4 641 910 A1**
(43) Date of publication of application: **29.10.2025**
(21) Application number: 23906304.3
(22) Date of filing: 07.03.2023
(51) Int. Cl.: H02M 7/5387, H02M 9/06

(54) **PULSE ELECTRIC POWER SUPPLY DEVICE, DIELECTRIC BARRIER DISCHARGE DEVICE, AND INDUCTION HEATING DEVICE**

(30) Priority: 23.12.2022 JP 2022206896
(71) Applicant: Nissin Inc., Takarazuka-shi, Hyogo-ken 665-0047 (JP)
(72) Inventor: ZHOU, Ziqiang, Takarazuka-shi, Hyogo 665-0047 (JP); INOUE, Sho, Takarazuka-shi, Hyogo 665-0047 (JP); OTSUKA, Takeo, Takarazuka-shi, Hyogo 665-0047 (JP); NANKO, Shohei, Takarazuka-shi, Hyogo 665-0047 (JP); NAKAMURA, Osamu, Takarazuka-shi, Hyogo 665-0047 (JP)
(74) Representative: Hauck Patent- und Rechtsanwälte PartmbB
(86) International application number: PCT/JP2023/008565
(87) International publication number: WO 2024/134918

(57) **Abstract**

A transformer 7 including a primary winding La and a secondary winding Lb, a pulse generation circuit 9 connected to the primary winding La and including at least one switching element SW1, a consumption circuit 13 connected in parallel to the pulse generation circuit 9, the consumption circuit 13 including a resistor R1 that consumes electric vibration energy Er occurring in the secondary winding Lb and transmitted to the primary winding La, and a switching element SW5 connected in series to the resistor R1, a switch controller 21 that switches on/off of the switching element SW1 and the switching element SW5, and a consumption time controller 23 that controls timing at and a period during which the switching element SW5 is switched to an on-state, are provided.

## Description

### Technical Field

The present invention relates to a pulse power supply device, a dielectric barrier discharge device using the pulse power supply device, and an induction heating device using the pulse power supply device.

### Background Art

Conventionally, as a pulse power supply device that outputs a rectangular wave, taking positive and negative step-like waveforms or pulse waveforms as examples, a four-switch inverter circuit or a four-switch pulse circuit using four switching elements is known (for example, Patent Literature 1). In such a four-switch circuit 100, as illustrated in FIG. 31, a series circuit of a first switching element Q1 and a second switching element Q2 and a series circuit of a third switching element Q3 and a fourth switching element Q4 are inserted in parallel with each other between the positive terminal and the negative terminal of DC power supply D. Then, a load La is inserted between a connection point T1 of the first switching element Q1 and the second switching element Q2 and a connection point T2 of the third switching element Q3 and the fourth switching element Q4.

In such a conventional four-switch circuit 100, a positive pulse wave is generated by turning on the first switching element Q1 and the fourth switching element Q4 among the four switching elements Q1 to Q4. In addition, a negative pulse wave is generated by turning on the second switching element Q2 and the third switching element Q3 among the four switching elements Q1 to Q4. In the conventional four-switch circuit 100, on/off of the four switching elements Q1 to Q4 is appropriately switched to alternately generate a positive pulse wave and a negative pulse wave.

Here, in a case where an inductive load exemplifying a motor as the load La is used in the four-switch circuit 100, energy corresponding to (1/2) ·LI² is accumulated in the load La by generating a positive pulse wave or a negative pulse wave. Note that, in the expression of (1/2) ·LI², L represents self-inductance (unit: H), and I represents current (unit: A) . When a pulse is generated in a state where the energy is accumulated, the current from the DC power supply D and the current from the inductive load overlap each other, the waveform of the pulse collapses, and it becomes difficult to generate a desired pulse.

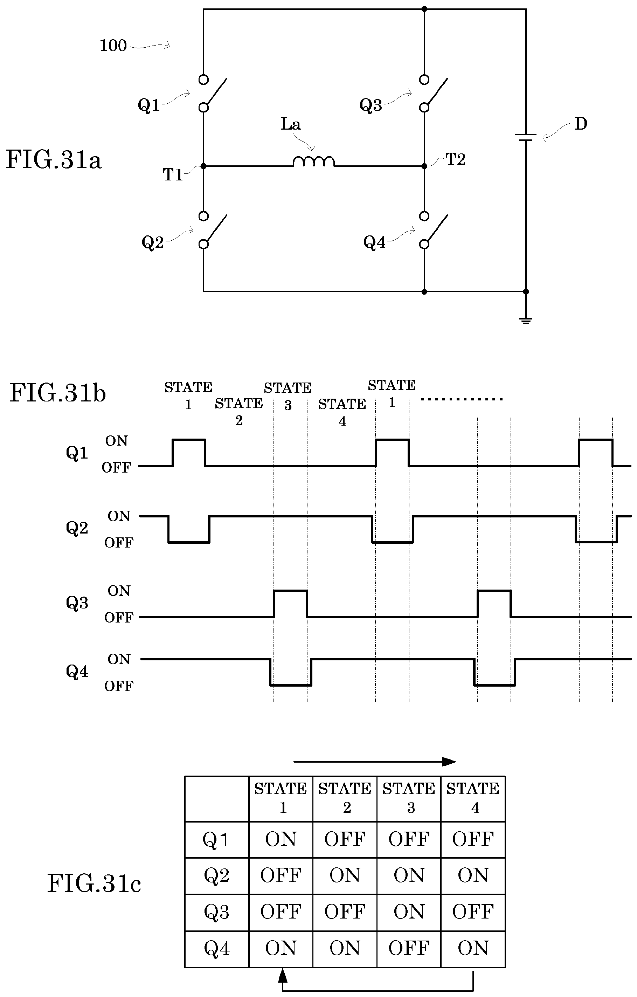

Therefore, in Patent Literature 1, after a positive pulse or a negative pulse is generated, the second switching element Q2 and the fourth switching element Q4 are turned on to perform an operation of discharging the energy accumulated in the load La. That is, as illustrated in FIGS. 31(b) and (c), first, the first switching element Q1 and the fourth switching element Q4 are turned on to generate a positive pulse wave (State 1). After the positive pulse wave is generated, the second switching element Q2 and the fourth switching element Q4 are turned on (State 2). The second switching element Q2 and the fourth switching element Q4 are turned on, so that the energy accumulated in the load La is discharged by the on-resistance of each switching element and the resistance component originally existing in a closed loop circuit.

After the energy accumulated in the load La by the generation of the positive pulse wave is discharged, the second switching element Q2 and the third switching element Q3 are turned on to generate a negative pulse wave (State 3). Then, after the negative pulse wave is generated, the second switching element Q2 and the fourth switching element Q4 are turned on (State 4). The second switching element Q2 and the fourth switching element Q4 are turned on, so that the energy accumulated in the load La is discharged again by the on-resistance of each switching element and the resistance component existing in the closed loop circuit. After the energy accumulated in the load La by the generation of the negative pulse wave is discharged, the switching elements Q1 to Q4 are controlled so as to be in State 1 again. Hereinafter, for each of the switching elements Q1 to Q4, the switching control is sequentially repeated in a combination mode of State 1, State 2, State 3, and State 4.

Such a four-switch circuit is used in a dielectric barrier discharge device, an induction heating device, or the like (for example, Patent Literature 2). That is, as illustrated in FIG. 32, in a dielectric barrier discharge device 101 using the four-switch circuit 100, the four-switch circuit 100 is disposed on the primary side of a high-voltage transformer 103 as power supply, and a discharge circuit 106 including a parallel plate electrode 105 is disposed on the secondary side of the high-voltage transformer 103. A dielectric plate 107 is disposed on at least one of an electrode 105a and an electrode 105b included in the parallel plate electrode 105.

By switching on/off of the switching elements Q1 to Q4 of the four-switch circuit 100 as illustrated in FIG. 31(b), the positive and negative pulse waves are alternately generated, and then, by applying pulse voltage to the parallel plate electrode 105 via the high-voltage transformer 103, plasma discharge is generated in the parallel plate electrode 105. In the dielectric barrier discharge device 101, using the plasma discharge generated in the parallel plate electrode, various treatments such as surface treatment of a substrate and exhaust gas treatment are performed. Note that, by disposing an inductive load instead of the parallel plate electrode 105 which is a capacitive load, the four-switch circuit 100 can also be used for an induction heating device.

### Citation List

### Patent Literature

Patent Literature 1: JP S63-316673 A
Patent Literature 2: JP H11-146659 A

### Summary of Invention

### Technical Problem

However, the conventional example having such a configuration has the following problems.

That is, in the conventional configuration, it is difficult to achieve the high-frequency of the four-switch circuit 100 which is a pulse power supply. In the dielectric barrier discharge device, when substrate surface treatment or the like is performed, it is required to improve the output of the pulse power supply in order to increase the treatment speed. As a main method of improving the output of the pulse power supply, there is a method of increasing the frequency of the pulse generated by the four-switch circuit 100 to increase the energy per unit time. However, in the conventional configuration, a desired pulse can be generated at a frequency of about several tens of kHz. On the other hand, as an example, under a condition of a high-frequency exceeding about 100 kHz, a pulse waveform collapses, and there is a concern that the desired plasma discharge cannot be generated. As a result, in the conventional four-switch circuit 100, the upper limit value of the output as the pulse power supply is low, and it is difficult to realize a high-output pulse power supply.

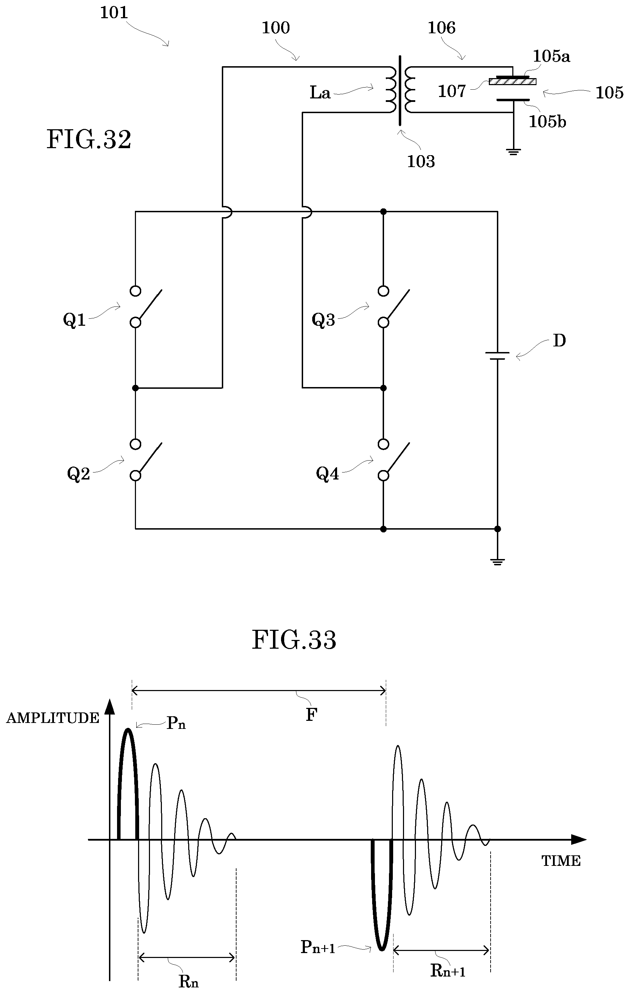

As a result of intensive studies by the inventors, ringing can be mentioned as a cause of hindering the high-frequency of the pulse. That is, as illustrated in FIG. 33, the ringing occurs for a predetermined time after an n-th pulse wave Pₙ is generated. Note that, the predetermined time during which the ringing occurs after the n-th pulse wave Pₙ is generated is hereinafter referred to as a ringing period Rₙ. The ringing occurs due to a capacitive load or an electric vibration between a parasitic capacitance inherent in each component and a transformer, and a ringing wave gradually attenuates over time.

In a case where the frequency of the pulse power supply is a relatively low frequency of about several tens of kHz, the ringing period Rₙ occurring after the n-th pulse wave is generated does not overlap with the (n+1)-th pulse wave Pₙ₊₁, so that a desired waveform of the pulse wave Pₙ₊₁ is maintained. On the other hand, in a case where the frequency of the pulse power supply is a relatively high frequency exceeding 100 kHz as an example, an interval F between the pulse wave Pₙ and the pulse wave Pₙ₊₁ becomes short, so that the ringing period Rₙ occurring after the n-th pulse wave Pₙ is generated overlaps with the generation time of the (n+1)-th pulse wave Pₙ₊₁. As a result of the overlap, the waveform of the ringing occurring in the ringing period Rₙ and the waveform of the pulse wave Pₙ₊₁ are combined, and the waveform of the pulse wave Pₙ₊₁ collapses from the initial shape, so that it becomes difficult to generate desired plasma discharge.

In addition, in the conventional four-switch circuit 100, when the switching elements Q2 and Q4 are turned on to discharge the energy accumulated in the inductive load La and the switching element Q1 or Q3 is turned on, through current flows and an element is damaged. That is, since the pulse wave cannot be oscillated while the energy accumulated in the inductive load La is discharged, it is more difficult to increase the frequency of the pulse in the conventional four-switch circuit 100.

The present invention has been made in view of such circumstances, and an object thereof is to provide a pulse power supply device capable of increasing the frequency of a pulse and improving the output, a dielectric barrier discharge device using the pulse power supply device, and an induction heating device using the pulse power supply device.

### Solution to Problem

In order to achieve such an object, the present invention has the following configurations.

That is, a pulse power supply device according to the present invention includes: a transformer including a primary winding and a secondary winding; a pulse wave generation circuit connected to the primary winding and including at least one pulse wave generation switching element; an electric vibration consumption circuit connected in parallel to the pulse wave generation circuit, the electric vibration consumption circuit including a consumption resistor that consumes the energy of electric vibration generated in the secondary winding and transmitted to the primary winding, and a resistance switching element connected in series to the consumption resistor; a switch controller that switches on/off of the pulse wave generation switching element and the resistance switching element; and a consumption time controller that controls timing at and a period during which the resistance switching element is switched to an on-state.

(Actions and Effects) According to this configuration, the pulse wave generation circuit and the electric vibration consumption circuit are connected in parallel to the primary winding of the transformer. The consumption resistor and the resistance switching element are connected in series to the electric vibration consumption circuit. The energy of the electric vibration generated in the secondary winding of the transformer and transmitted to the primary winding is consumed by the consumption resistor disposed in the electric vibration consumption circuit. Therefore, since the ringing caused by the electric vibration is quickly attenuated by the electric vibration consumption circuit, the ringing period after the generation of the pulse wave can be shortened. By shortening the ringing period, in a case where the frequency of the pulse wave is improved, it is possible to avoid combining the ringing waveform occurring after the pulse wave with the pulse wave formed next time. Accordingly, since it is possible to prevent the waveform of the pulse wave from collapsing while improving the frequency of the pulse wave, it is possible to realize the pulse power supply device having a higher frequency.

In addition, the pulse power supply device according to the present invention includes the switch controller and the consumption time controller. The switch controller switches on/off of the pulse wave generation switching element and resistance switching element. The consumption time controller controls the timing at and a period during which the resistance switching element is switched to an on-state. The switch controller generates a pulse wave by switching the pulse wave generation switching element to on. In addition, by switching the resistance switching element to on, the energy of the electric vibration occurring in the secondary winding and transmitted to the primary winding is consumed by the consumption resistor. Therefore, it is possible to appropriately switch between a state of generating a pulse wave and a state of quickly attenuating the ringing due to electric vibration.

By controlling the timing at and a period during which the resistance switching element is switched to an on-state, the consumption time controller controls the timing at and a period during which the energy of the electric vibration is consumed by the consumption resistor. When the consumption time controller is provided, timing at and a period during which the energy of the electric vibration is consumed can be arbitrarily changed, so that the length of the ringing period can be appropriately adjusted. That is, it is possible to quickly consume an unnecessary ringing wave while maintaining the ringing wave necessary for continuation of the output in the pulse power supply device. Accordingly, it is also possible to improve the frequency in the pulse power supply device while stabilizing the output in the pulse power supply device.

In order to achieve such an object, the present invention may have the following configuration.

That is, the pulse power supply device according to the present invention includes: the transformer including the primary winding, the secondary winding, and a tertiary winding insulated from one another; the pulse wave generation circuit connected to the primary winding and including at least one pulse wave generation switching element; the electric vibration consumption circuit connected to the tertiary winding, the electric vibration consumption circuit including the consumption resistor that consumes the energy of electric vibration occurring in the secondary winding and transmitted to the tertiary winding, and the resistance switching element connected in series to the consumption resistor; the switch controller that switches on/off of the pulse wave generation switching element and the resistance switching element; and the consumption time controller that controls the timing at and a period during which the resistance switching element is switched to an on-state.

(Actions and Effects) According to this configuration, the transformer includes the primary winding, the secondary winding, and the tertiary winding that are insulated from each other. The pulse wave generation circuit is connected to the primary winding of the transformer, and the electric vibration consumption circuit is connected to the tertiary winding of the transformer. The consumption resistor and the resistance switching element are connected in series to the electric vibration consumption circuit. The electric vibration occurring in the secondary winding of the transformer is transmitted to the tertiary winding and consumed by the consumption resistor disposed in the electric vibration consumption circuit. Therefore, since the ringing occurred due to the electric vibration is quickly attenuated by the electric vibration consumption circuit, the ringing period after the generation of the pulse wave can be shortened. By shortening the ringing period, in a case where the frequency of the pulse wave is improved, it is possible to avoid combining the ringing waveform occurring after the pulse wave with the pulse wave formed next time. Accordingly, since it is possible to prevent the waveform of the pulse wave from collapsing while improving the frequency of the pulse wave, it is possible to realize the pulse power supply device having a higher frequency.

In addition, the pulse power supply device according to the present invention includes the switch controller and the consumption time controller. The switch controller switches on/off of the pulse wave generation switching element and resistance switching element. The consumption time controller controls the timing at and a period during which the resistance switching element is switched to an on-state. The switch controller generates a pulse wave by switching the pulse wave generation switching element to on. In addition, by switching the resistance switching element to on, the energy of the electric vibration occurring in the secondary winding and transmitted to the primary winding is consumed by the consumption resistor. Therefore, it is possible to appropriately switch between a state of generating a pulse wave and a state of quickly attenuating the ringing due to electric vibration.

By controlling the timing at and a period during which the resistance switching element is switched to an on-state, the consumption time controller controls the timing at and a period during which the energy of the electric vibration is consumed by the consumption resistor. When the consumption time controller is provided, timing at and a period during which the energy of the electric vibration is consumed can be arbitrarily changed, so that the length of the ringing period can be appropriately adjusted. That is, it is possible to quickly consume an unnecessary ringing wave while maintaining the ringing wave necessary for the continuation of the output in the pulse power supply device. Accordingly, it is also possible to improve the frequency in the pulse power supply device while stabilizing the output in the pulse power supply device.

In addition, in this configuration, the energy of the electric vibration is consumed in the tertiary winding different from the primary winding that generates the pulse wave. That is, since the tertiary winding on which the electric vibration consumption circuit is disposed is electrically insulated from the primary winding on which the pulse wave generation circuit is disposed, any point in the electric vibration consumption circuit can be grounded. As a result, destabilization of the potential can be avoided, so that the occurrence of the malfunction in the pulse power supply device can be more reliably prevented.

In addition, in the above-described invention, it is preferable that the electric vibration consumption circuit further includes a capacitor that accumulates the energy of the electric vibration, and each of the capacitor and the consumption resistor connected in parallel to each other is connected in series to the resistance switching element.

(Actions and Effects) According to this configuration, the electric vibration consumption circuit further includes the capacitor that accumulates the energy of the electric vibration. In the electric vibration consumption circuit, the capacitor and the consumption resistor are connected in parallel. Then, each of the capacitor and the consumption resistor is connected in series to the resistance switching element. With such a configuration, when the resistance switching element is switched on, the energy of the electric vibration is accumulated by the capacitor in parallel with the energy consumption of the electric vibration by the consumption resistor. As a result, the processing efficiency of the energy of the electric vibration can be greatly improved, and thus the ringing period can be further shortened. That is, the frequency can be further improved by further shortening the ringing period.

In addition, in the above-described invention, it is preferable that the electric vibration consumption circuit further includes the capacitor that accumulates the energy of the electric vibration and an energy regeneration unit that regenerates the energy of the electric vibration accumulated in the capacitor, a regenerative circuit having a configuration in which the capacitor and the energy regeneration unit are connected in parallel and the consumption resistor are connected in parallel, and the electric vibration consumption circuit has a configuration in which each of the consumption resistor and the regenerative circuit is connected in series to the resistance switching element.

(Actions and Effects) According to this configuration, the electric vibration consumption circuit further includes the capacitor that accumulates the energy of the electric vibration. In the electric vibration consumption circuit, the capacitor and the consumption resistor are connected in parallel. Then, each of the capacitor and the consumption resistor is connected in series to the resistance switching element. With such a configuration, when the resistance switching element is switched on, the energy of the electric vibration is accumulated by the capacitor in parallel with the energy consumption of the electric vibration by the consumption resistor. As a result, the processing efficiency of the energy of the electric vibration can be greatly improved, and thus the ringing period can be further shortened. That is, the frequency can be further improved by further shortening the ringing period.

In addition, the configuration further includes the energy regeneration unit that regenerates the energy of the electric vibration accumulated in the capacitor. The energy regeneration unit is connected in parallel to the capacitor and included in the regenerative circuit. The regenerative circuit is connected in parallel with the consumption resistor. Then, each of the consumption resistor and the regenerative circuit is connected in series to the resistance switching element. With such a configuration, the energy of the electric vibration accumulated in the capacitor can be reused as regenerative energy by the regenerative circuit. Therefore, it is possible to improve the frequency of the pulse power supply device and improve the energy efficiency in the pulse power supply device.

In addition, in the above-described invention, it is preferable that the pulse wave generation circuit is an H-bridge circuit in which the four pulse wave generation switching elements SW1, SW2, SW3, and SW4 are H-bridge-connected, and the switch controller sequentially and repeatedly performs switching control in four on/off combination modes of States 1 to 4 illustrated in the following Table 1 for each of the four pulse wave generation switching elements SW1, SW2, SW3, and SW4 and the resistance switching element SW5.

**[Table 1]**

| | STATE 1 | STATE 2 | STATE 3 | STATE 4 |
|---|---|---|---|---|
| SW1 | ON | OFF | OFF | OFF |
| SW2 | OFF | OFF | ON | OFF |
| SW3 | OFF | OFF | ON | OFF |
| SW4 | ON | OFF | OFF | OFF |
| SW5 | OFF | ON | OFF | ON |

(Actions and Effects) According to this configuration, the pulse wave generation circuit is the H-bridge circuit, and the modes of States 1 to 4 are sequentially repeated with respect to the control of the switching element. In this case, by alternately repeating State 1 and State 3 with respect to the control of the switching element, positive and negative pulse waves having polarities opposite to each other can be alternately generated. In addition, the switch controller operates between State 1 and State 3 so as to be in State 2 in which the resistance switching element is turned on, whereby the electric vibration occurring in State 1 is quickly consumed, and the ringing is attenuated. Therefore, even under a condition where the frequency is relatively high, it is possible to avoid a situation where the waveform of the pulse wave related to State 3 collapses due to the ringing occurring after State 1. Furthermore, between State 3 and State 1, the switch controller operates so as to be in State 4 in which the resistance switching element is turned on, whereby the electric vibration occurring in State 3 is quickly consumed, and the ringing is attenuated. Therefore, even under a condition where the frequency is relatively high, it is possible to avoid a situation where the waveform of the pulse wave related to State 1 collapses due to the ringing occurring after State 3.

In addition, in the above-described invention, the pulse wave generation circuit is the H-bridge circuit in which the four pulse wave generation switching elements SW1, SW2, SW3, and SW4 are H-bridge-connected, the electric vibration consumption circuit has two sets of configurations in which each of the capacitor and the consumption resistor connected in parallel to each other is connected in series to the resistance switching element, and
it is preferable that the switch controller sequentially and repeatedly performs switching control on each of the four pulse wave generation switching elements SW1, SW2, SW3, and SW4 and the two resistance switching elements SW5 and SW6 in six on/off combination modes of States 1 to 6 illustrated in the following Table 2.

**[Table 2]**

| | STATE 1 | STATE 2 | STATE 3 | STATE 4 | STATE 5 | STATE 6 |
|---|---|---|---|---|---|---|
| SW1 | ON | OFF | OFF | OFF | OFF | OFF |
| SW2 | OFF | OFF | OFF | ON | OFF | OFF |
| SW3 | OFF | OFF | OFF | ON | OFF | OFF |
| SW4 | ON | OFF | OFF | OFF | OFF | OFF |
| SW5 | OFF | ON | OFF | OFF | OFF | OFF |
| SW6 | OFF | OFF | OFF | OFF | ON | OFF |

(Actions and Effects) According to this configuration, the pulse wave generation circuit is the H-bridge circuit, and has two sets of configurations in which each of the capacitor and the consumption resistor connected in parallel to each other is connected in series to the resistance switching element. Then, the modes of States 1 to 6 are sequentially repeated with respect to the control of the switching element.

In this case, by alternately repeating State 1 and State 4 with respect to the control of the switching element, positive and negative pulse waves having polarities opposite to each other can be alternately generated. In addition, after State 1, the switch controller operates so as to be in State 2 in which one resistance switching element SW5 is turned on, whereby the electric vibration occurring in State 1 is consumed by the consumption resistor. At this time, since the electric vibration that cannot be consumed by the consumption resistor is rapidly accumulated in the capacitor, the ringing can be more rapidly attenuated. Therefore, it is possible to avoid a situation where the waveform of the pulse wave related to State 4 collapses due to the ringing occurring after State 1 while further improving the frequency.

Then, after State 2, State 3 in which all the switching elements are turned off is executed. The capacitor and the consumption resistor are connected in parallel, so that the electric vibration energy accumulated in the capacitor can be continued to be consumed by the consumption resistor even in a state where the resistance switching element is off. Therefore, it is possible to efficiently consume the electric vibration energy while shortening the time for turning on the resistance switching element.

In addition, after State 4, the switch controller operates so as to be in State 5 in which the other resistance switching element SW6 is turned on, whereby the electric vibration generated in State 4 is consumed by the consumption resistor. At this time, since the electric vibration that cannot be consumed by the consumption resistor is rapidly accumulated in the capacitor, the ringing can be more rapidly attenuated. Therefore, it is possible to avoid a situation where the waveform of the pulse wave related to State 1 collapses due to the ringing occurring after State 4 while further improving the frequency. Furthermore, by separately providing the electric vibration consumption circuit used to attenuate the ringing occurring in State 1 and the electric vibration consumption circuit used to attenuate the ringing occurring in State 4, larger electric vibration energy can be consumed rapidly.

In order to achieve such an object, the present invention may have the following configuration.

That is, the dielectric barrier discharge device according to the present invention includes the pulse power supply device having the above-described characteristics, and a dielectric barrier discharge unit connected to the secondary winding as a load circuit of the pulse power supply device.

(Actions and Effects) According to this configuration, the above-described pulse power supply device is used as a power supply device of the dielectric barrier discharge device, and the dielectric barrier discharge unit connected to the secondary winding of the transformer is provided as the load circuit of the pulse power supply device. Therefore, it is possible to improve the frequency of the pulse wave while maintaining the waveform of the pulse wave. As a result, under the condition of a higher frequency, plasma can be generated and various types of plasma treatment can be suitably performed.

In order to achieve such an object, the present invention may have the following configuration.

That is, the induction heating device according to the present invention includes the pulse power supply device having the above-described characteristics, and an induction heating unit connected to the secondary winding as a load circuit of the pulse power supply device.

(Actions and Effects) According to this configuration, the above-described pulse power supply device is used as a power supply device of the induction heating device, and the induction heating unit connected to the secondary winding of the transformer is provided as the load circuit of the pulse power supply device. Therefore, it is possible to improve the frequency of the pulse wave while maintaining the waveform of the pulse wave. As a result, under the condition of a higher frequency, induction heating can be suitably performed. Advantageous Effects of Invention

According to the pulse power supply device, the dielectric barrier discharge device, and the induction heating device according to the present invention, the pulse wave generation circuit and the electric vibration consumption circuit are connected in parallel to the primary winding of the transformer. The consumption resistor and the resistance switching element are connected in series to the electric vibration consumption circuit. The electric vibration occurring in the secondary winding of the transformer and transmitted to the primary winding is consumed by the consumption resistor disposed in the electric vibration consumption circuit. Therefore, since the ringing occurred due to the electric vibration is quickly attenuated by the electric vibration consumption circuit, the ringing period after the generation of the pulse wave can be shortened. By shortening the ringing period, in a case where the frequency of the pulse wave is improved, it is possible to avoid combining the ringing waveform occurring after the pulse wave with the pulse wave formed next time. Accordingly, since it is possible to prevent the waveform of the pulse wave from collapsing while improving the frequency of the pulse wave, it is possible to realize the pulse power supply device having a higher frequency.

In addition, the pulse power supply device according to the present invention includes the switch controller and the consumption time controller. The switch controller switches on/off of the pulse wave generation switching element and resistance switching element. The consumption time controller controls the timing at and a period during which the resistance switching element is switched to an on-state. The switch controller generates a pulse wave by switching the pulse wave generation switching element to on. In addition, by switching the resistance switching element to on, the electric vibration occurring in the secondary winding and transmitted to the primary winding is consumed by the consumption resistor. Therefore, it is possible to appropriately switch between a state of generating a pulse wave and a state of quickly attenuating the ringing due to electric vibration.

By controlling the timing at and a period during which the resistance switching element is switched to an on-state, the consumption time controller controls the timing at and the period during which the electric vibration is consumed by the consumption resistor. When the consumption time controller is provided, timing at and a period during which the electric vibration is consumed can be arbitrarily changed, so that the length of the ringing period can be appropriately adjusted. That is, it is possible to quickly consume an unnecessary ringing wave while maintaining the ringing wave necessary for the continuation of the output in the pulse power supply device. Accordingly, it is also possible to improve the frequency in the pulse power supply device while stabilizing the output in the pulse power supply device.

### Brief Description of Drawings

FIG. 1 is a diagram illustrating an overall configuration of a dielectric barrier discharge device including a pulse power supply device according to a first embodiment.
FIG. 2 is a time chart illustrating operations of switching elements of the pulse power supply device according to the first embodiment.
FIG. 3 is a list view illustrating combination modes of on/off of switching elements in each state of the pulse power supply device according to the first embodiment.
FIG. 4 is a diagram illustrating State 1 of the pulse power supply device according to the first embodiment.
FIG. 5 is a diagram illustrating State 2 of the pulse power supply device according to the first embodiment.
FIG. 6 is a diagram for explaining effects of the pulse power supply device according to the first embodiment.
(a) is a diagram illustrating an output voltage waveform of the pulse power supply device according to a conventional example, (b) is a diagram illustrating the output voltage waveform of the pulse power supply device according to the first embodiment, and (c) is a diagram illustrating the output voltage waveform of the pulse power supply device according to the first embodiment in a case where a pulse wave is increased in frequency.

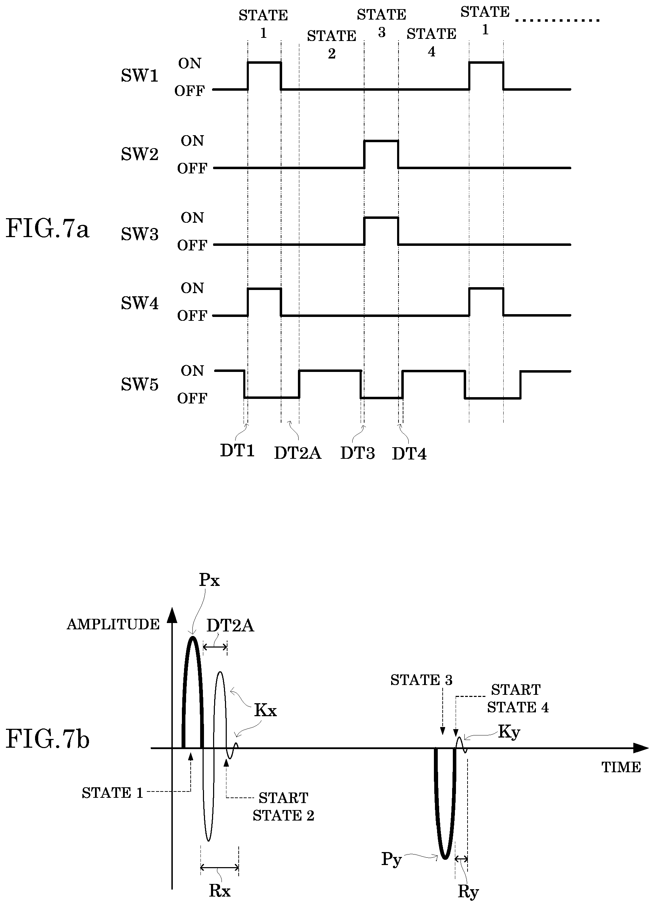

FIG. 7 is a diagram for explaining a configuration of a comparative example in which dead time DT2 is lengthened regarding the pulse power supply device according to the first embodiment.
(a) is a time chart illustrating operations of the switching elements of the pulse power supply device according to the comparative example of the first embodiment, and (b) is a diagram illustrating the output voltage waveform of the pulse power supply device according to the comparative example of the first embodiment.

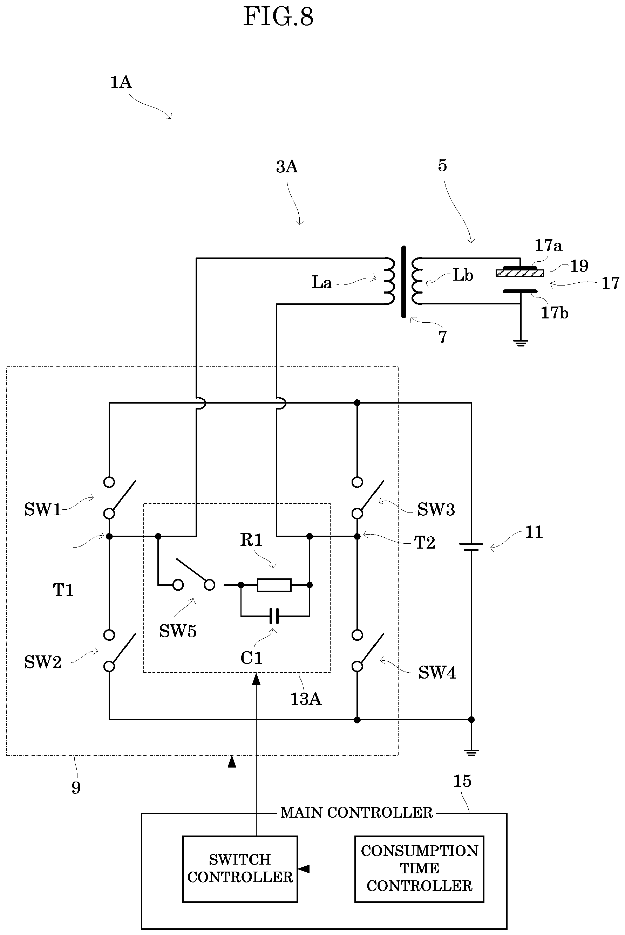

FIG. 8 is a diagram illustrating an overall configuration of the dielectric barrier discharge device including the pulse power supply device according to a second embodiment.

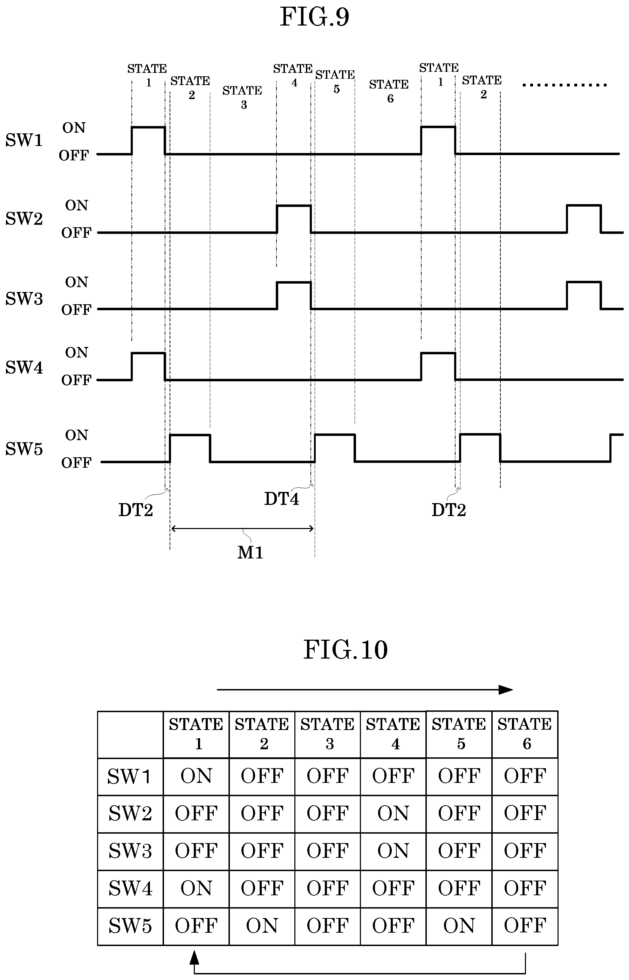

FIG. 9 is a time chart illustrating operations of the switching elements of the pulse power supply device according to the second embodiment.
FIG. 10 is a list view illustrating combination modes of on/off of switching elements in each state of the pulse power supply device according to the second embodiment.

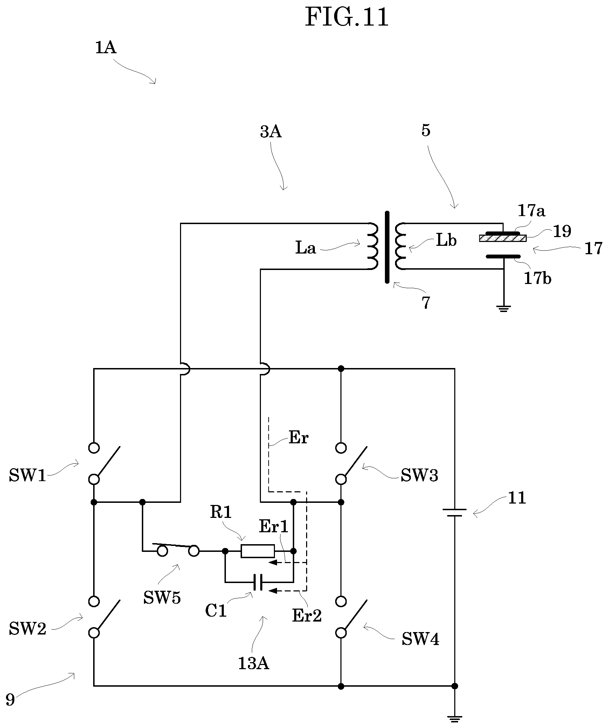

FIG. 11 is a diagram illustrating State 2 of the pulse power supply device according to the second embodiment.

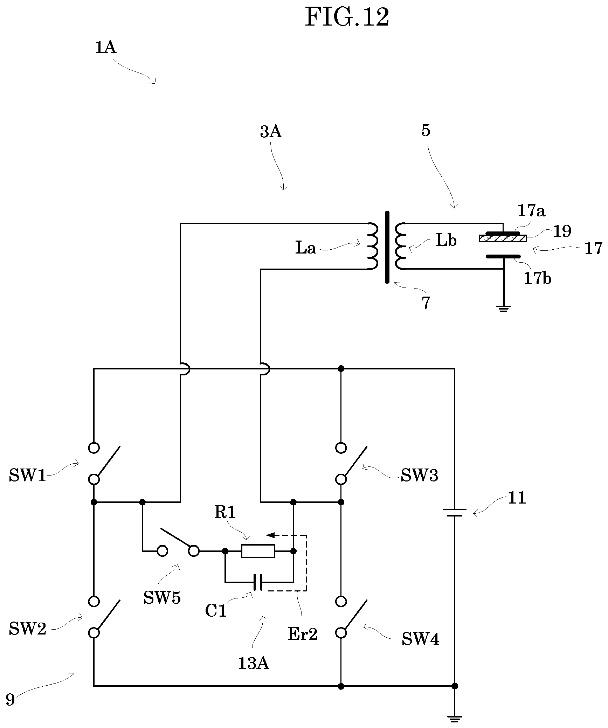

FIG. 12 is a diagram illustrating State 3 of the pulse power supply device according to the second embodiment.

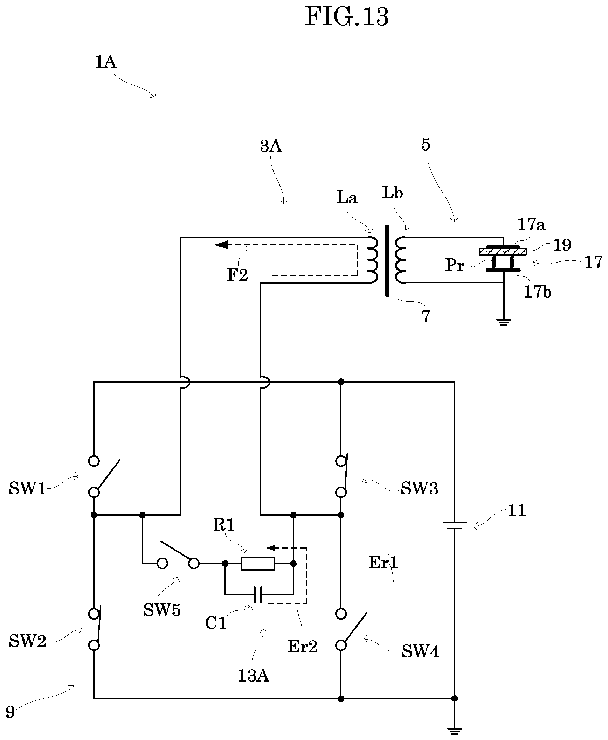

FIG. 13 is a diagram illustrating State 4 of the pulse power supply device according to the second embodiment.

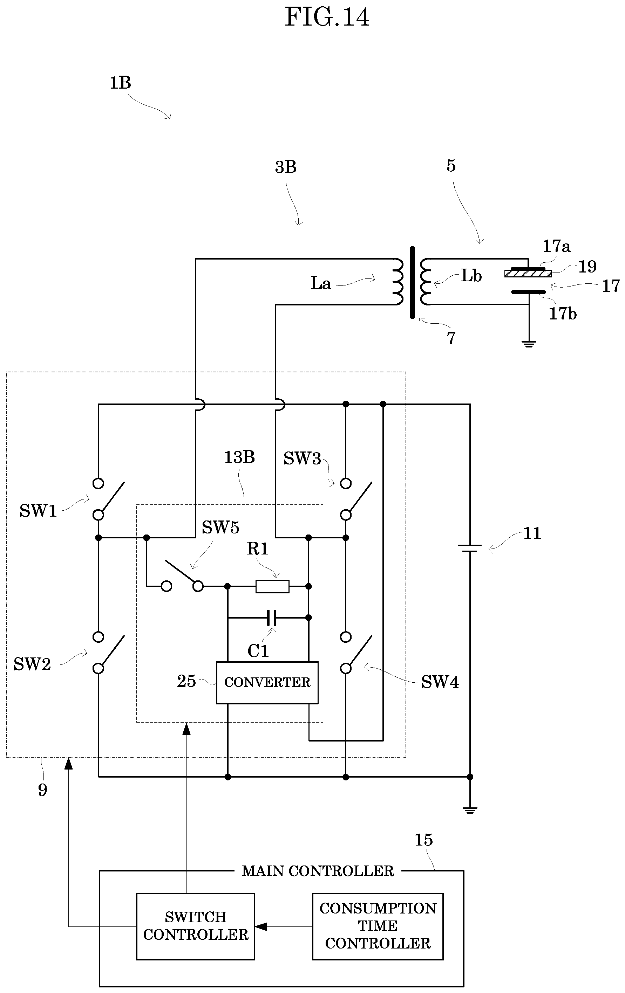

FIG. 14 is a diagram illustrating an overall configuration of the dielectric barrier discharge device including the pulse power supply device according to a third embodiment.

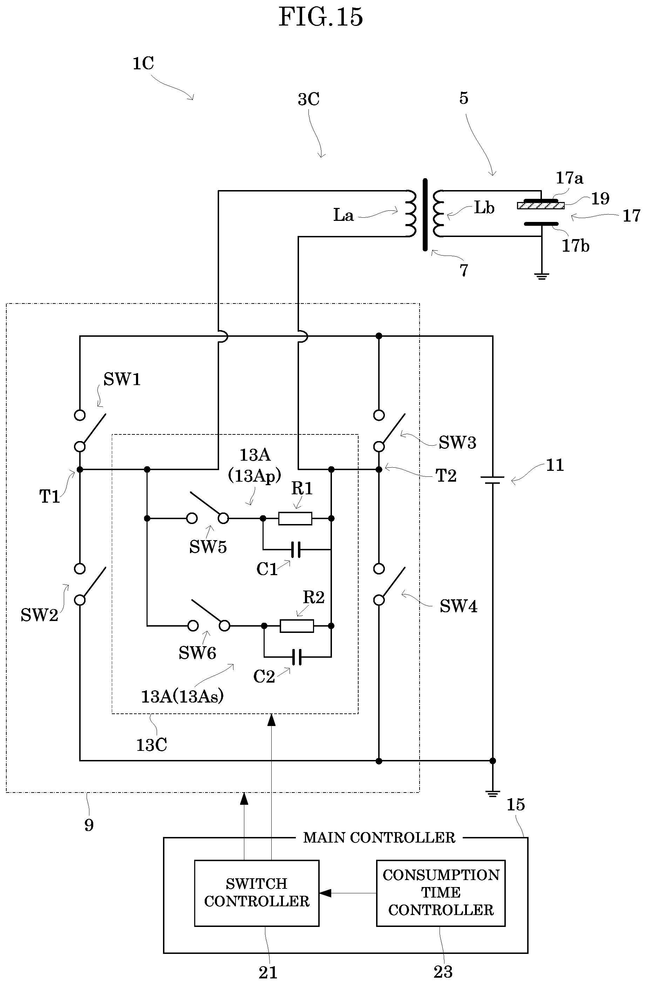

FIG. 15 is a diagram illustrating an overall configuration of the dielectric barrier discharge device including the pulse power supply device according to a fourth embodiment.

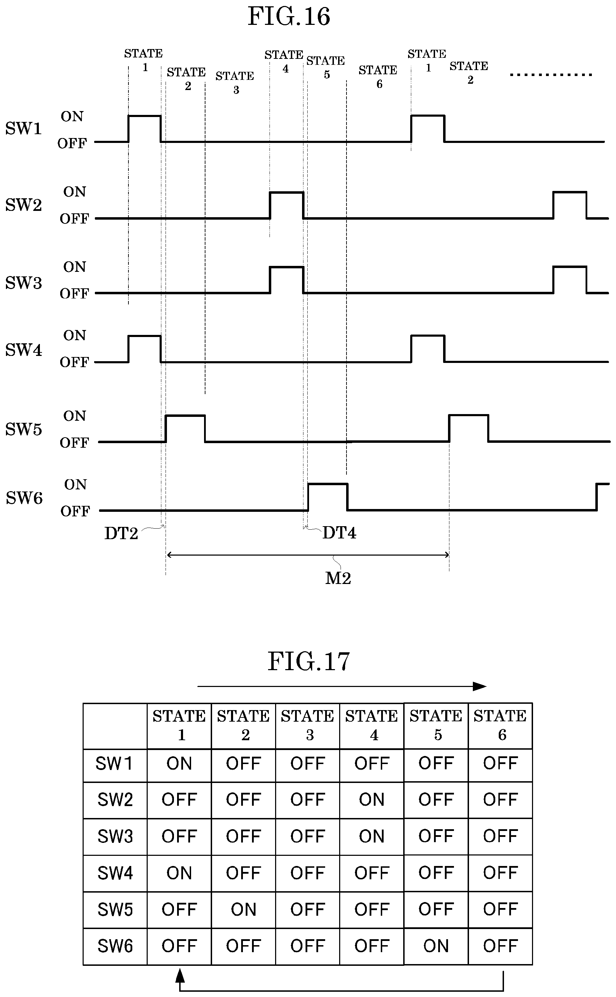

FIG. 16 is a time chart illustrating operations of the switching elements of the pulse power supply device according to the fourth embodiment.
FIG. 17 is a list view illustrating combination modes of on/off of switching elements in each state of the pulse power supply device according to the fourth embodiment.

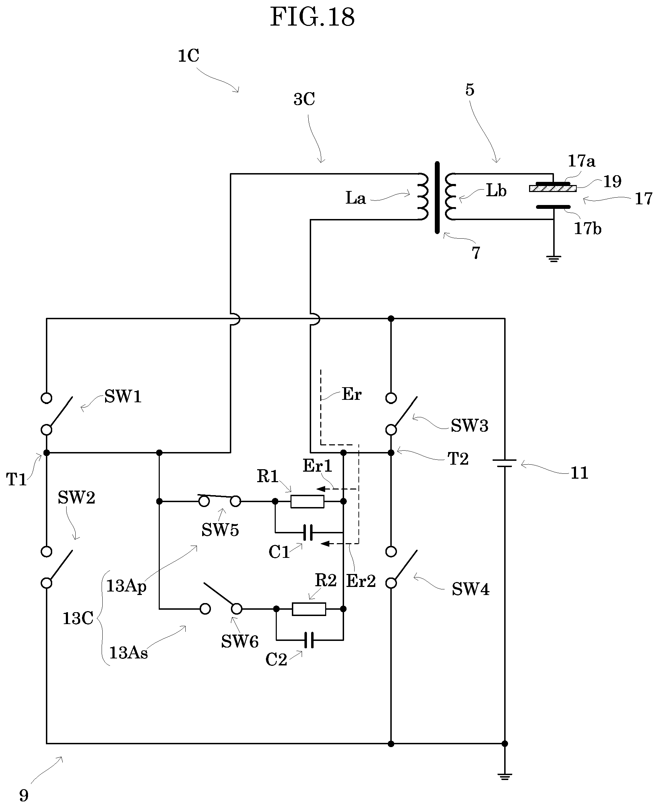

FIG. 18 is a diagram illustrating State 2 of the pulse power supply device according to the fourth embodiment.

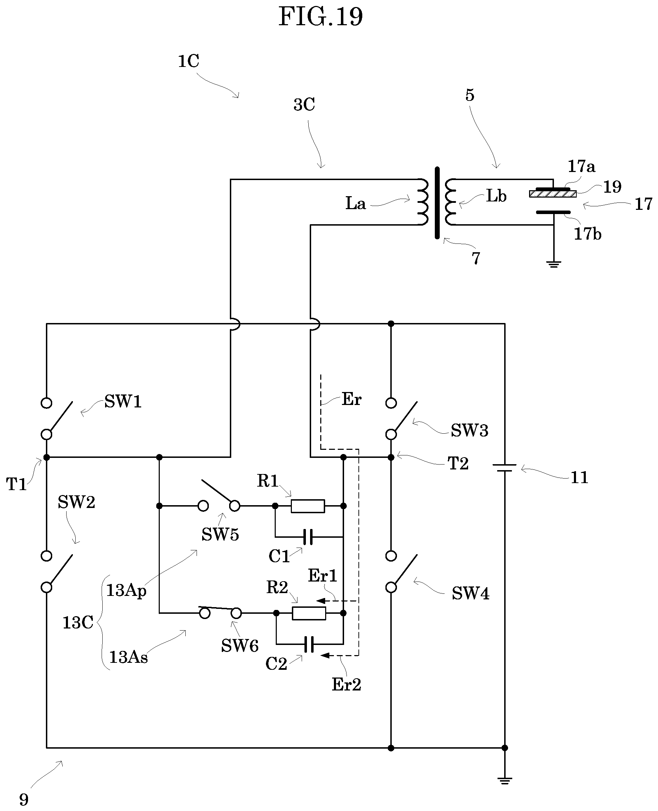

FIG. 19 is a diagram illustrating State 5 of the pulse power supply device according to the fourth embodiment.

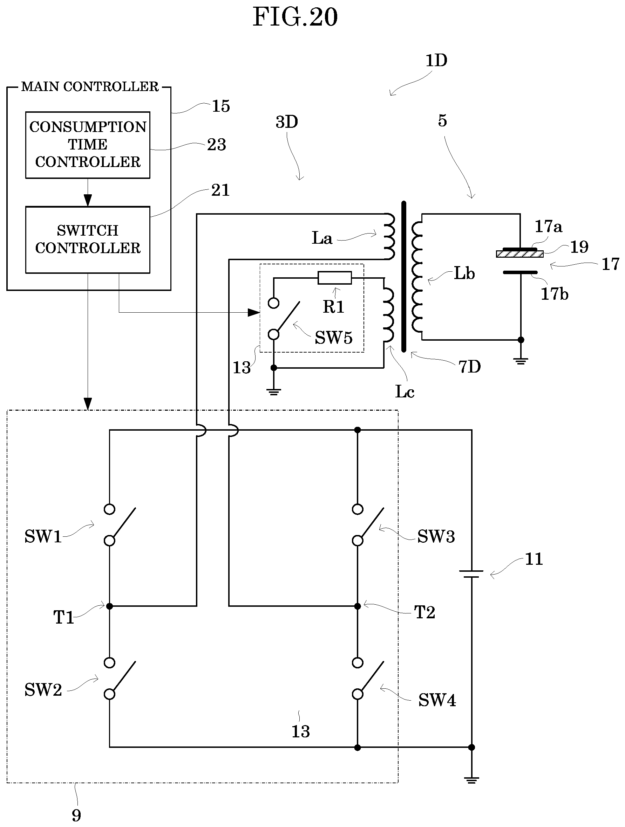

FIG. 20 is a diagram illustrating an overall configuration of the dielectric barrier discharge device including the pulse power supply device according to a fifth embodiment.

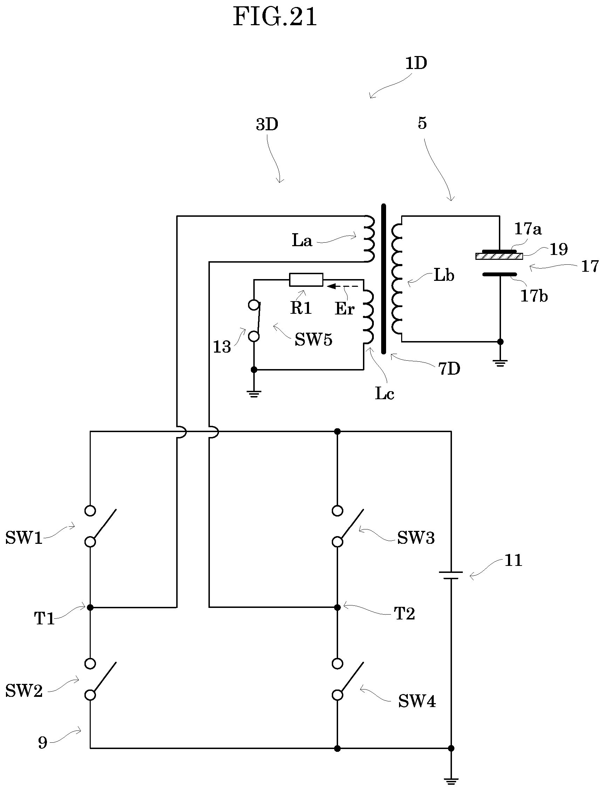

FIG. 21 is a diagram illustrating State 2 of the pulse power supply device according to the fifth embodiment.

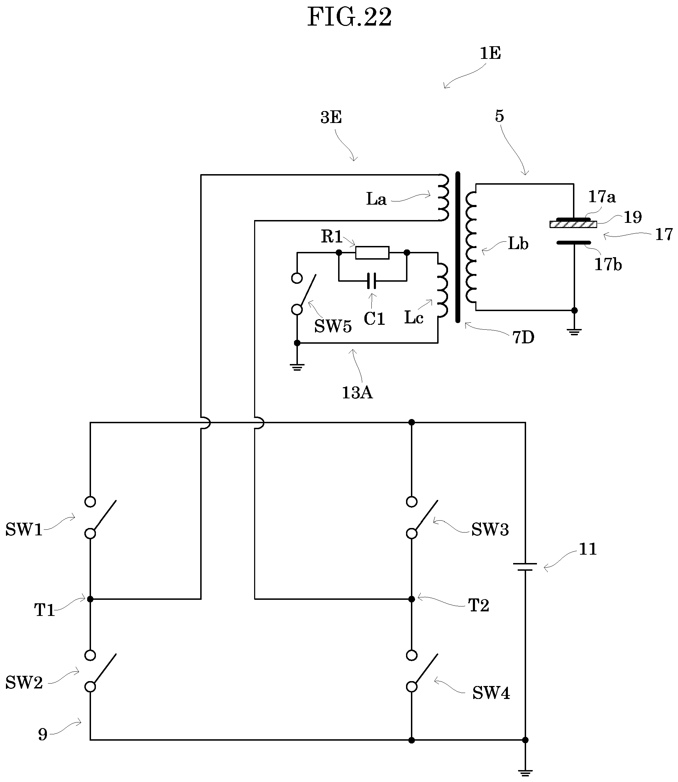

FIG. 22 is a diagram illustrating an overall configuration of the dielectric barrier discharge device including the pulse power supply device according to a first modification.

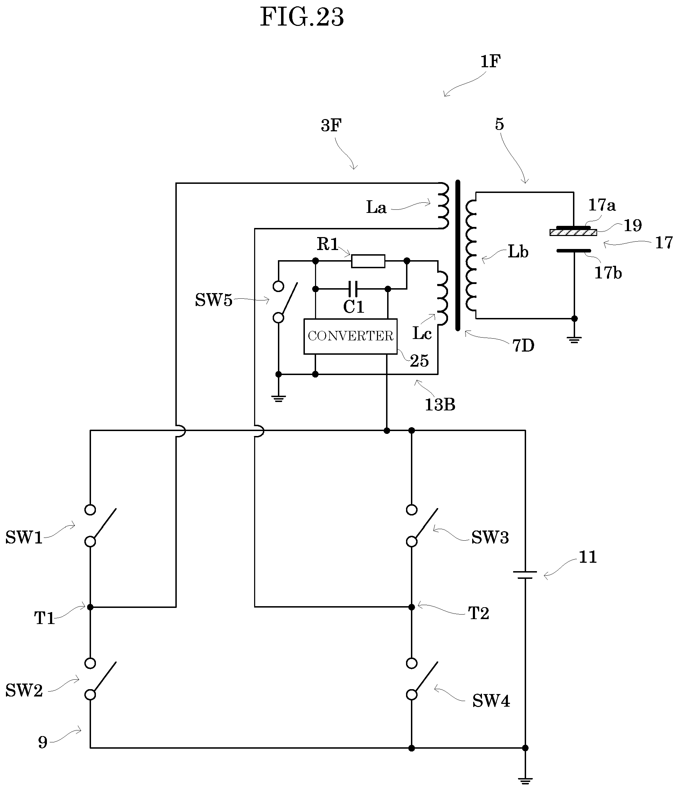

**FIG.** 23 is a diagram illustrating an overall configuration of the dielectric barrier discharge device including the pulse power supply device according to a second modification.

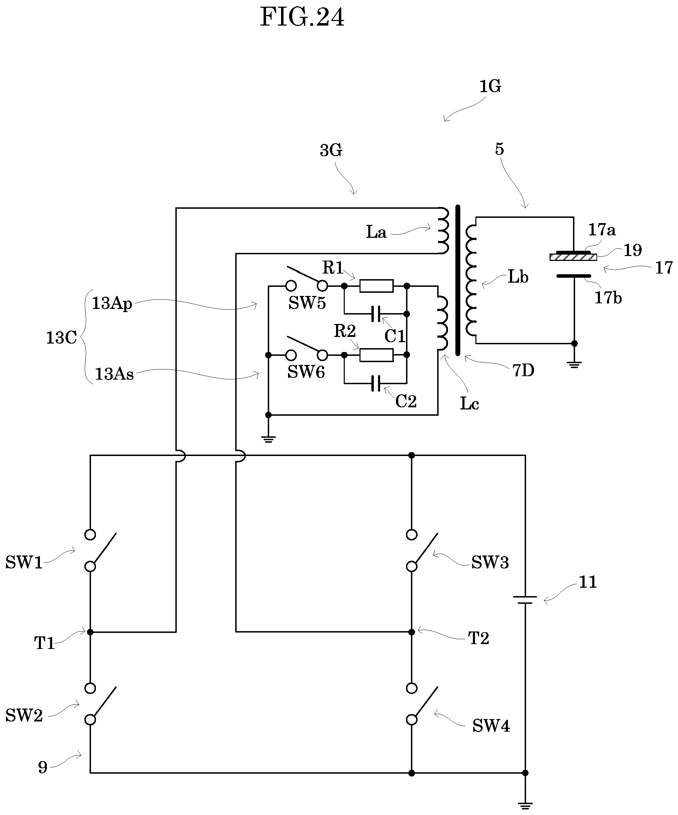

**FIG.** 24 is a diagram illustrating an overall configuration of the dielectric barrier discharge device including the pulse power supply device according to a third modification.

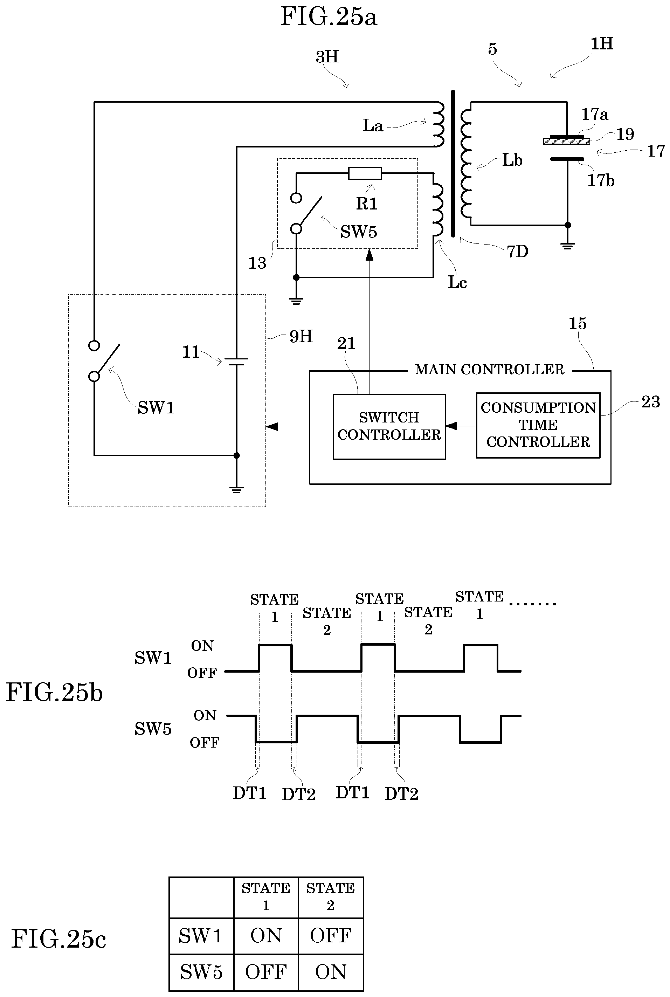

**FIG.** 25 is a diagram for explaining the dielectric barrier discharge device including the pulse power supply device according to a fourth modification.
(a) is a diagram illustrating an overall configuration of the dielectric barrier discharge device including the pulse power supply device according to the fourth modification, (b) is a time chart illustrating operations of the switching elements of the pulse power supply device according to the fourth modification, and (c) is a list view illustrating combination modes of on/off of the switching elements in each state of the pulse power supply device according to the fourth modification.

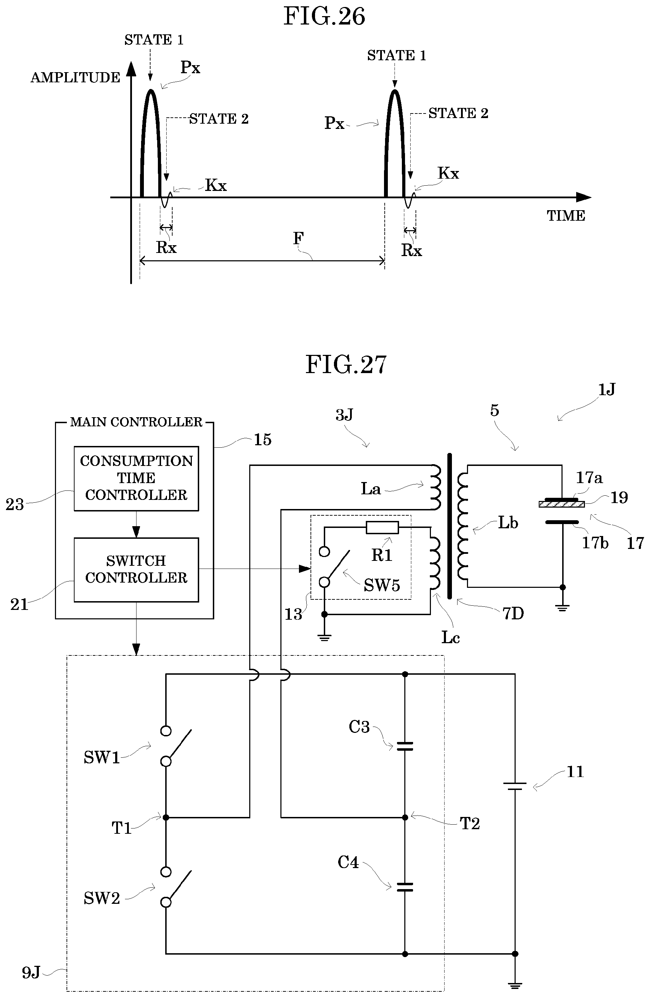

**FIG.** 26 is a diagram illustrating an output voltage waveform of the pulse power supply device according to the fourth modification.
FIG. 27 is a diagram illustrating an overall configuration of the dielectric barrier discharge device including the pulse power supply device according to a fifth modification.

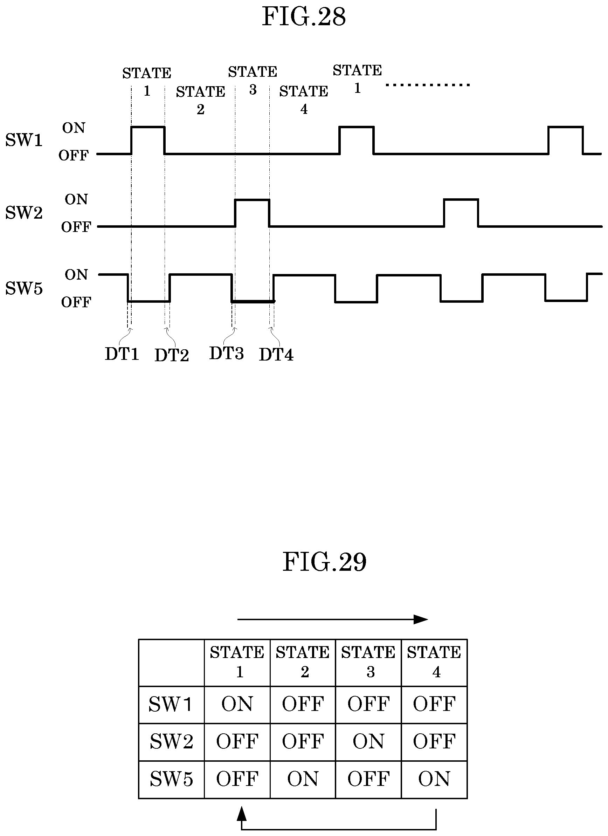

FIG. 28 is a time chart illustrating operations of the switching elements of the pulse power supply device according to the fifth modification.
FIG. 29 is a list view illustrating combination modes of on/off of switching elements in each state of the pulse power supply device according to the fifth modification.

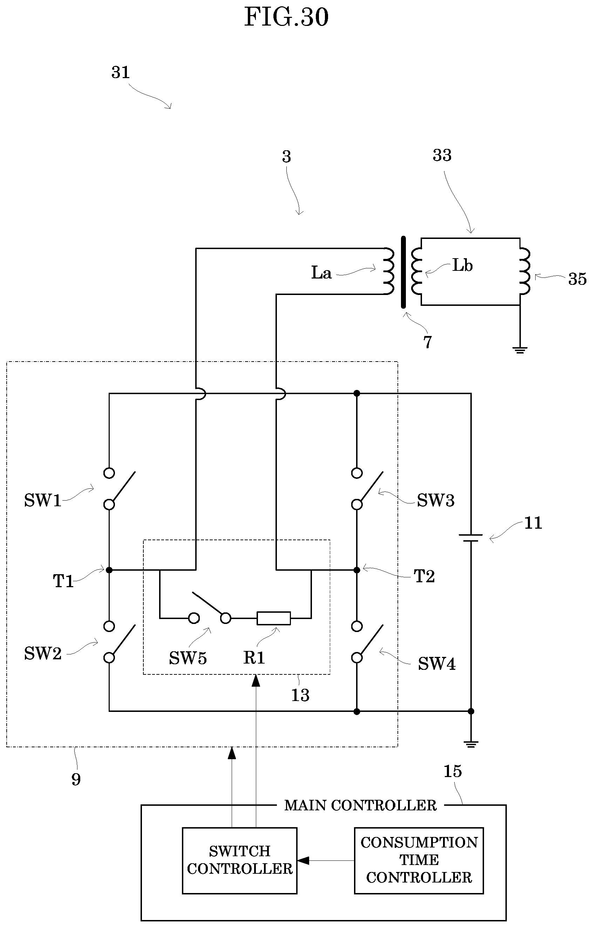

FIG. 30 is a diagram illustrating an overall configuration of an induction heating device including the pulse power supply device according to the first embodiment.
FIG. 31 is a diagram illustrating a configuration of a conventional example.
(a) is a diagram illustrating a four-switch circuit according to the conventional example, (b) is a time chart illustrating operations of the switching elements of the four-switch circuit according to the conventional example, and (c) is a list view illustrating combination modes of on/off of the switching elements in each state of the four-switch circuit according to the conventional example.
FIG. 32 is a diagram for explaining the dielectric barrier discharge device including the four-switch circuit according to the conventional example.
FIG. 33 is a diagram illustrating the output voltage waveform of the dielectric barrier discharge device including the four-switch circuit according to the conventional example.

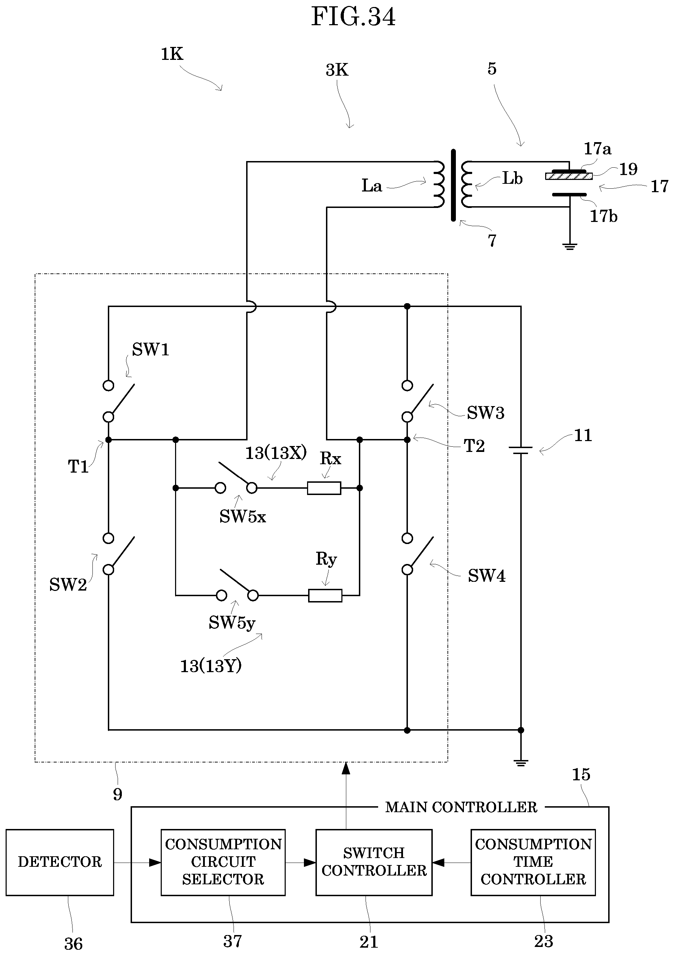

FIG. 34 is a diagram illustrating an overall configuration of the dielectric barrier discharge device including the pulse power supply device according to a sixth modification.

### Description of Embodiments

### First Embodiment

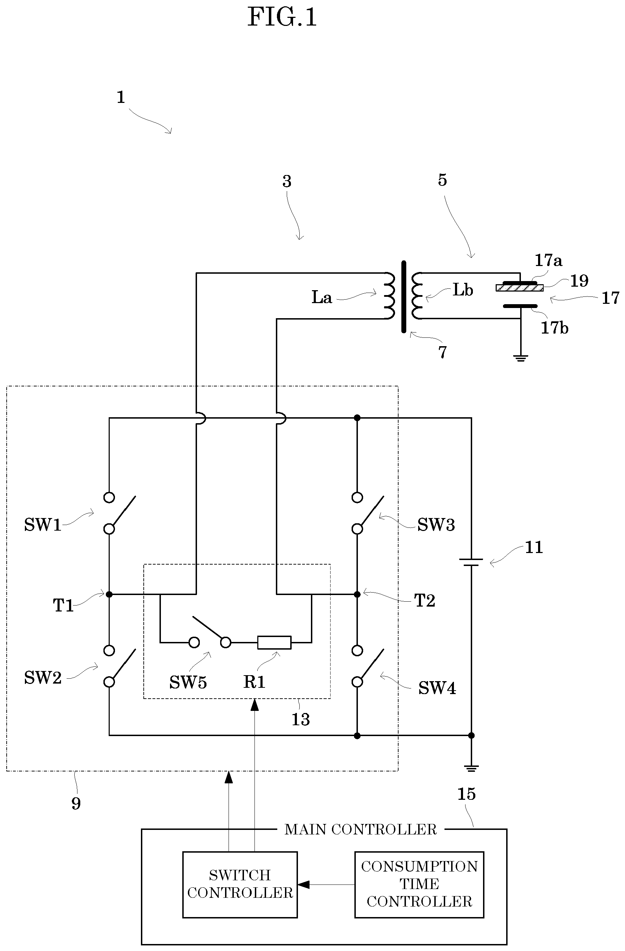

Hereinafter, a first embodiment of the present invention will be described with reference to the drawings. FIG. 1 is a schematic diagram of a dielectric barrier discharge device 1 including a pulse power supply device 3 according to a first embodiment.

### <Description of Overall Configuration>

As illustrated in FIG. 1, the dielectric barrier discharge device 1 according to the first embodiment includes the pulse power supply device 3 and a discharger 5. The pulse power supply device 3 includes a transformer 7, a pulse generation circuit 9, a power supply 11, a consumption circuit 13, and a main controller 15.

The transformer 7 includes a primary winding La and a secondary winding Lb, and appropriately boosts the output of the pulse power supply device 3 and transmits the output to the discharger 5. The pulse generation circuit 9 is connected to the primary winding La and generates a pulse wave. The power supply 11 is connected to the pulse generation circuit 9 and supplies power to the pulse generation circuit 9. In the first embodiment, the DC power supply is used as the power supply 11.

The discharger 5 is connected to the secondary winding Lb and includes a parallel plate electrode 17 corresponding to a capacitive load. The parallel plate electrode 17 includes a first electrode 17a and a second electrode 17b. The first electrode 17a and the second electrode 17b are arranged in parallel so as to face each other with a predetermined space. A dielectric 19 is disposed on at least one of the first electrode 17a and the second electrode 17b. FIG. 1 illustrates, as an example, a configuration in which the dielectric 19 is provided on the first electrode 17a. By applying the pulse voltage output from the pulse power supply device 3 to the parallel plate electrode 17, plasma is generated by dielectric barrier discharge in a space sandwiched between the first electrode 17a and the second electrode 17b. The discharger 5 corresponds to the dielectric barrier discharge unit in the present invention.

In the first embodiment, it is assumed that an H-bridge circuit which is the four-switch circuit is used as the pulse generation circuit 9. That is, as illustrated in FIG. 1, in the pulse generation circuit 9 according to the first embodiment, a first circuit in which a first switching element SW1 and a second switching element SW2 are connected in series and a second circuit in which a third switching element SW3 and a fourth switching element SW4 are connected in series are inserted in parallel between the positive terminal and the negative terminal of the power supply 11. Then, the primary winding La corresponding to the inductive load is inserted between the connection point T1 of the switching element SW1 and the switching element SW2 and the connection point T2 of the switching element SW3 and the switching element SW4.

The on/off states of the switching elements SW1 to SW4 provided in the pulse generation circuit 9 control on/off of the generation of the pulse wave in the pulse generation circuit 9 and the polarity of the generated pulse wave. In the first embodiment, the switching elements SW1 to SW4 correspond to the pulse wave generation switching elements in the present invention.

The consumption circuit 13 is connected in parallel to the pulse generation circuit 9. The consumption circuit 13 has a configuration in which a resistor R1 and the switching element SW5 are connected in series. The resistor R1 suppresses the ringing by consuming the energy of the electric vibration mainly occurring between the transformer 7 and the parallel plate electrode 17 which is a capacitive load. When the switching element SW5 provided in the consumption circuit 13 is turned on, the energy of the electric vibration is transmitted to the resistor R1, and the energy of the electric vibration can be consumed by the resistor R1. In addition, when the switching element SW5 is turned off, the consumption circuit 13 is electrically disconnected from the pulse generation circuit 9. In the first embodiment, the resistor R1 corresponds to a consumption resistor in the present invention. In the first embodiment, the switching element SW5 corresponds to a resistance switching element in the present invention.

The main controller 15 is a control circuit that integrally controls each configuration of the pulse power supply device 3, and includes a switch controller 21 and a consumption time controller 23. The switch controller 21 is a control circuit that independently performs control to switch on/off states of each of the switching elements SW1 to SW4 provided in the pulse generation circuit 9 and the switching element SW5 provided in the consumption circuit 13. A mode in which the switch controller 21 switches each switching element will be described later.

The consumption time controller 23 is a control circuit that controls the switch controller 21 such that timing at and a period during which the switching element SW5 is turned on become predetermined timing and period. Timing at and a period during which the switching element SW5 is turned on are determined in advance based on contents input using an input unit (not illustrated) for inputting an operator's instruction. Examples of the configuration of the input unit include a keyboard type, a mouse type, and a touch panel type input device. The main controller 15 integrally controls each configuration of the pulse power supply device 3 according to the content of the instruction input using the input unit. The consumption time controller 23 can adjust so that the period (ringing period) during which the ringing occurs after the pulse wave (impulse signal) is generated has a desired length by controlling the timing at and a period during which the switching element SW5 is turned on.

### <Operation of Pulse Power Supply Device>

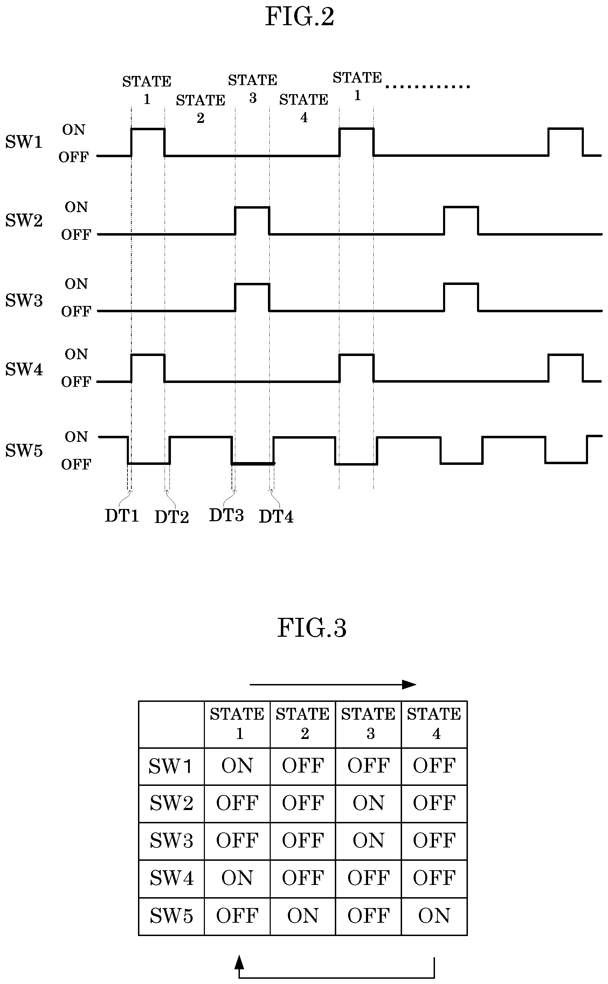

Here, the operation of the dielectric barrier discharge device 1 including the pulse power supply device 3 in the first embodiment will be described. In the dielectric barrier discharge device 1 according to the first embodiment, as illustrated in FIGS. 2 and 3, regarding the combination of the on/off states of the switching element SW1 to the switching element SW5, States 1 to 4 are repeated with the four states as one cycle. Hereinafter, the control operation of the switch controller 21 and the operation of the dielectric barrier discharge device 1 in each state will be described in detail.

First, the operation in State 1 will be described. In State 1, the switch controller 21 controls each of the switching elements SW1 to SW5 so that the switching element SW1 and the switching element SW4 are switched to an on-state, while the switching element SW2, the switching element SW3, and the switching element SW5 are switched to an off-state.

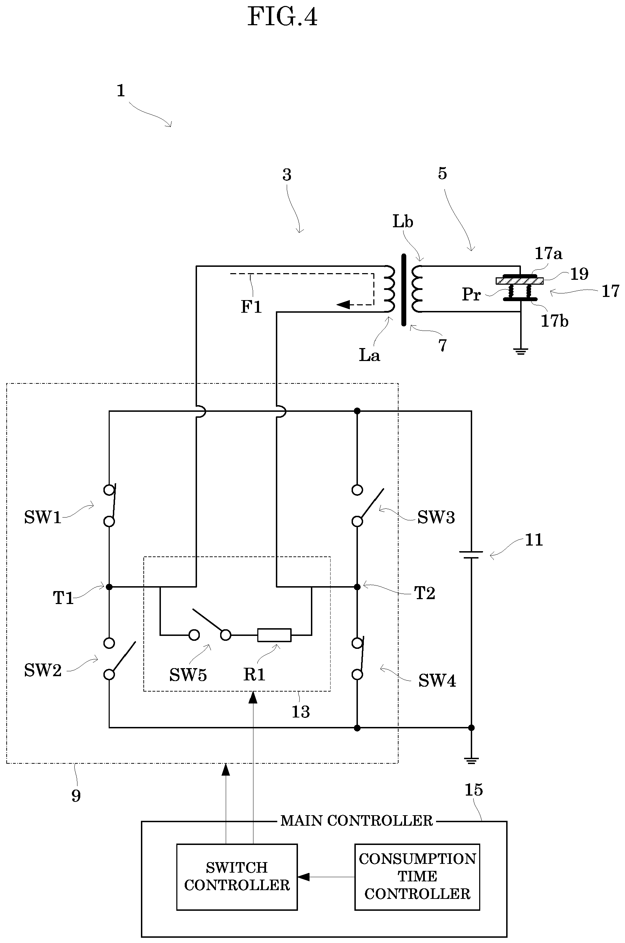

When the switching elements SW1 to SW5 are switched according to the combination mode of State 1, the primary winding La and the pulse generation circuit 9 are electrically connected. Then, power is supplied from the power supply 11 to the pulse generation circuit 9, and the current flows in the direction of F1 via the switching element SW1 as illustrated in FIG. 4. As a result, the positive pulse voltage by a positive pulse wave Px is applied from the primary winding La to the secondary winding Lb, and the dielectric barrier discharge is generated in the parallel plate electrode 17. That is, plasma Pr due to the dielectric barrier discharge is generated between the first electrode 17a and the second electrode 17b. Note that, in FIG. 4 and the like, description of the main controller 15 is appropriately omitted.

When the pulse voltage is applied to the parallel plate electrode 17 via the secondary winding Lb, electric vibration occurs between the parallel plate electrode 17 which is a capacitive load and the transformer 7. That is, when the dielectric barrier discharge is generated in the parallel plate electrode 17, the energy corresponding to (1/2) ·CV² is accumulated in the parallel plate electrode 17 even after the discharge is stopped, and the energy is resonated between the parallel plate electrode 17 and the transformer 7 and electric vibration occurs. Note that, in the expression of (1/2) ·CV², C represents capacitance (unit: F), and V represents voltage (unit: V).

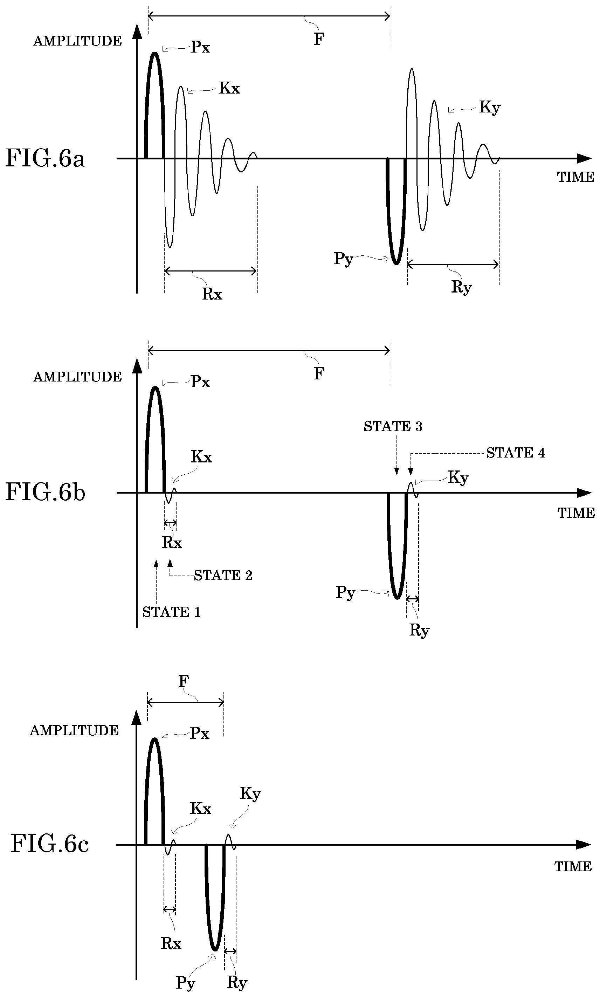

Since the primary winding La and the secondary winding Lb are electromagnetically coupled in the transformer 7, the electric vibration that has occurred is transmitted from the secondary side (discharge unit 5 side) to the primary side (pulse power supply device 3 side) via the transformer 7. The electrical vibration causes the occurrence of a ringing wave after the generation of a pulse wave. That is, as illustrated in FIG. 6(a), a ringing wave Kx occurs after the oscillation of the positive pulse wave Px due to the electric vibration. Therefore, in the pulse power supply device 3 according to the first embodiment, the ringing wave Kx is attenuated by the operation in State 2.

Secondly, the operation in State 2 will be described. In State 2, the switch controller 21 controls each of the switching elements SW1 to SW5 so that all of the four switching elements SW1 to SW4 disposed in the pulse generation circuit 9 are switched to an off-state, while the switching element SW5 disposed in the consumption circuit 13 is switched to an on-state.

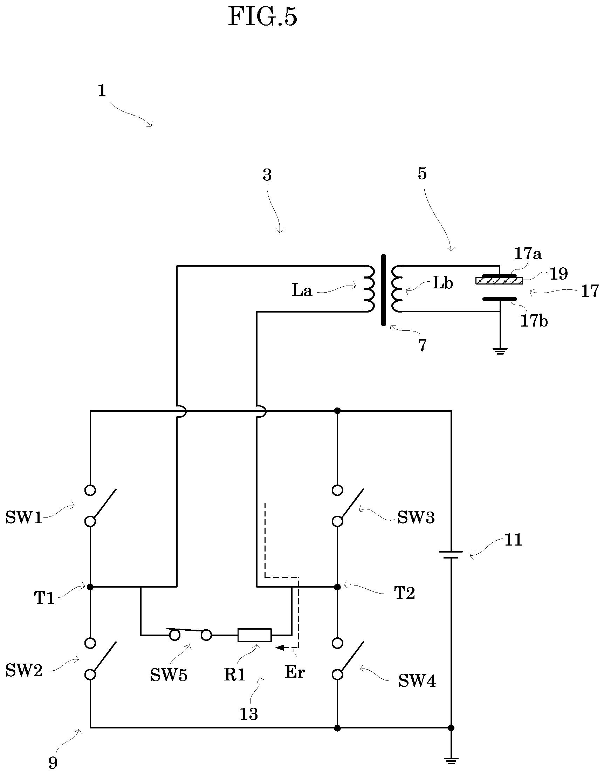

When the switching elements SW1 to SW5 are switched according to the combination mode of State 2, the primary winding La and the pulse generation circuit 9 are electrically disconnected, and the primary winding La and the consumption circuit 13 are electrically connected. As a result, as illustrated in FIG. 5, the energy of the electric vibration (electric vibration energy Er) flows to the consumption circuit 13, and the electric vibration energy Er is quickly consumed in the resistor R1 provided in the consumption circuit 13. When the energy is consumed in the resistor R1, the electric vibration energy Er quickly disappears on the primary side. In this case, since the primary winding La and the secondary winding Lb are electromagnetically coupled, transmission of the electric vibration energy Er from the primary side to the secondary side is also prevented. As a result, by disposing the resistor R1 on the primary side, the electric vibration energy Er rapidly disappears also on the secondary side. Therefore, the ringing wave Kx occurring after the positive pulse wave Px is generated in State 1 is rapidly attenuated by the operation in State 2 and disappears. Accordingly, the ringing period after a pulse signal (pulse wave) is oscillated in State 1 can be significantly shortened.

Thirdly, the operation in State 3 will be described. In State 3, the switch controller 21 controls each of the switching elements SW1 to SW5 so that the switching element SW2 and the switching element SW3 are switched to an on-state, while the switching element SW1, the switching element SW4, and the switching element SW5 are switched to an off-state.

When the switching elements SW1 to SW5 are switched according to the combination mode of State 3, the primary winding La and the pulse generation circuit 9 are electrically connected, and power is supplied from the power supply 11 to the pulse generation circuit 9. Then, the current flows in a direction opposite to a reference sign F1 illustrated in FIG. 4 via the switching element SW3. That is, in State 3, the voltage having a polarity opposite to that of State 1 is applied. As a result, negative pulse voltage due to a negative pulse wave Py is applied from the primary winding La to the secondary winding Lb, and dielectric barrier discharge is generated in the parallel plate electrode 17. That is, the plasma Pr due to the dielectric barrier discharge is generated between the first electrode 17a and the second electrode 17b.

When the negative pulse voltage is applied to the parallel plate electrode 17, electric vibration occurs between the parallel plate electrode 17 which is a capacitive load and the transformer 7 similarly to State 1. That is, as illustrated in FIG. 6(a), a ringing wave Ky occurs after the generation of the negative pulse wave Py due to the electric vibration after discharge. Therefore, in the pulse power supply device 3 according to the first embodiment, the ringing wave Ky is attenuated by the operation in State 4.

Fourthly, the operation in State 4 will be described. In State 4, the switch controller 21 controls each of the switching elements SW1 to SW5 so that all of the four switching elements SW1 to SW4 disposed in the pulse generation circuit 9 are switched to an off-state, while the switching element SW5 disposed in the consumption circuit 13 is switched to an on-state. That is, the combination mode of on/off of the switching elements SW1 to SW5 in State 4 is the same as the combination mode in State 2.

When the switching elements SW1 to SW5 are switched according to the combination mode in State 4, the primary winding La and the consumption circuit 13 are electrically connected. As a result, as illustrated in FIG. 5, the electric vibration energy Er flows to the consumption circuit 13, and the electric vibration energy Er is quickly consumed in the resistor R1. Since the primary winding La and the secondary winding Lb are electromagnetically coupled, the electric vibration energy Er is consumed in the resistor R1, so that the electric vibration quickly disappears on the primary side of the transformer 7. As a result, the electric vibration quickly disappears also on the secondary side of the transformer 7. Therefore, the ringing wave (ringing wave Ky) occurring after a negative pulse signal (negative pulse wave Py) is oscillated in State 3 is rapidly attenuated by the operation in State 4. Accordingly, the ringing period Ry after the negative pulse wave Py is oscillated in State 3 can also be significantly shortened.

The operation in State 4 is completed, so that a series of operations with States 1 to 4 as one cycle is completed. Thereafter, the state returns to State 1 from State 4, and a series of operations including States 1 to 4 is appropriately repeated to execute plasma processing by the dielectric barrier discharge.

Note that, as illustrated in FIG. 2, dead time DT1 and dead time DT2 are provided so that any of the switching elements SW1 to SW4 provided in the pulse generation circuit 9 and the switching element SW5 provided in the consumption circuit 13 are not simultaneously turned on. That is, at the timing when the dead time DT1 elapses after the switching element SW5 is switched to an off-state, the switching elements SW1 and SW4 are switched to an on-state and State 1 is started. Then, at the timing when the dead time DT2 elapses from the timing when the switching elements SW1 and SW4 are switched to an off-state and State 1 ends, the switching element SW5 is switched from an off-state to an on-state and State 2 is started.

Note that, the dead times DT3 and DT4 are similarly provided before and after State 3. That is, at the timing when the dead time DT3 elapses after the switching element SW is switched to an off-state, the switching elements SW2 and SW3 are switched to an on-state, and State 3 is started. Then, at the timing when the dead time DT4 elapses from the timing when the switching elements SW2 and SW3 are switched to an off-state and State 3 ends, the switching element SW5 is switched from an off-state to an on-state, and State 4 is started.

The lengths of the dead time DT1 to the dead time DT4 can be set by inputting desired numerical values using the input unit (not illustrated). By controlling the operation of the switch controller 21 according to the set numerical values of the dead time DT1 to the dead time DT4, the consumption time controller 23 controls the start timing and the execution periods of States 1 to 4. That is, the start timing and the execution period of States 2 and 4, in other words, the start timing and the execution period of the operation of consuming the electric vibration energy Er are controlled by the consumption time controller 23.

### <Effects of Configuration of First Embodiment>

In the pulse power supply device 3 according to the first embodiment, the frequency of the pulse signal can be improved by disposing the consumption circuit 13 in parallel with the pulse generation circuit 9. FIG. 6 is a diagram illustrating an effect of frequency improvement by the pulse power supply device 3 according to the first embodiment. FIG. 6(a) is a diagram illustrating a voltage waveform on the output side in the conventional power supply device, and FIG. 6(b) is a diagram illustrating a voltage waveform on the output side in the pulse power supply device 3 of the first embodiment.

Generally, when the pulse signal is generated in the pulse power supply device, electric vibration occurs on the secondary winding side of the transformer and transmitted to the primary winding side. As a result, as illustrated in FIG. 6(a), the ringing wave Kx occurs after the switching element is switched to oscillate the positive pulse wave Px as in State 1. In addition, a ringing wave Ky occurs even after the switching element is switched to oscillate the negative pulse wave Py as in State 3.

In the conventional power supply device, since a circuit intended to actively consume electric vibration is not provided, the electric vibration is gradually attenuated by a resistance component originally existing in a switching element, a line, or the like provided in a circuit that generates a pulse wave. Therefore, in the conventional configuration, it takes a relatively long time to attenuate the electric vibration. Therefore, as illustrated in FIG. 6(a), each of the ringing period Rx during which the ringing wave Kx occurs and the ringing period Ry during which the ringing wave Ky occurs is prolonged. In a case where the ringing period Rx is long, if the interval F between the pulse wave Px and the pulse wave Py is shortened, the pulse wave Py overlaps with the ringing wave Kx, and a situation easily occurs in which the waveform of the pulse wave Py collapses. When the waveform of the pulse wave Py collapses, it is difficult to execute desired dielectric barrier discharge. Therefore, in the conventional configuration in which the ringing periods Rx and Ry are relatively long, it is difficult to improve the frequency of the pulse wave while maintaining the shape of the pulse wave.

On the other hand, the pulse power supply device 3 according to the first embodiment includes the consumption circuit 13 separately from the pulse generation circuit 9 that generates pulse waves Px and Py. Then, the pulse generation circuit 9 and the consumption circuit 13 are connected in parallel on the primary winding La side of the transformer 7. The consumption circuit 13 includes the switching element SW5 and the resistor R1, and is configured such that when the switching element SW5 is switched to an on-state, the primary winding La and the consumption circuit 13 are electrically connected, and consumption of electric vibration by the resistor R1 is started.

That is, the device according to the first embodiment includes the consumption circuit 13 for the purpose of consuming the energy of the electric vibration as a circuit different from the pulse generation circuit 9 that generates a pulse wave. In this case, the switching element SW5 is turned on after the plasma discharge is generated by the generation of the pulse wave, so that the energy of the electric vibration occurring after the generation of the pulse wave is quickly consumed by the consumption circuit 13 and disappears. As a result, as illustrated in FIG. 6(b), the ringing wave Kx and the ringing wave Ky occurring after the generation of the pulse wave due to the electric vibration are quickly attenuated and disappear. Therefore, each of the ringing period Rx during which the ringing wave Kx occurs and the ringing period Ry during which the ringing wave Ky occurs is significantly shortened as compared with the conventional pulse power supply device.

When the ringing periods Rx and Ry are shortened, as illustrated in FIG. 6(c), even if the interval F between the pulse wave Px and the pulse wave Py is shortened, the oscillation time of the pulse wave Py can be avoided from overlapping with the ringing period Rx. That is, even when the interval F is shortened to increase the frequency of the pulse wave, the pulse wave Py and the ringing wave Kx are combined to prevent the pulse wave Py from collapsing from a desired shape, so that the waveforms of the pulse waves Px and Py can be maintained in a desired shape while improving the frequencies of the pulse waves Px and Py. Therefore, it is possible to realize a pulse power supply device having both suitable oscillation of the pulse wave and higher-frequency of the pulse wave.

In addition, in the pulse power supply device 3 according to the first embodiment, the consumption circuit 13 includes the switching element SW5 and is configured to arbitrarily change the timing and period of switching on/off of the switching element SW5 by the switch controller 21 and the consumption time controller 23. That is, after the positive pulse wave Px is oscillated in State 1, the timing when State 2 is started and the period during which State 2 is continued can be arbitrarily set. Similarly, after the negative pulse wave Py is oscillated in State 3, the timing when State 4 is started and the period during which State 4 is continued can be arbitrarily set. In other words, when the switching element SW5, the switch controller 21, and the consumption time controller 23 are provided, the lengths of the dead time DT2 and the dead time DT4 illustrated in FIG. 2 can be appropriately changed.

In the pulse power supply device, it may be desirable to leave a certain amount of the ringing waves depending on the output condition of the pulse wave or the configuration on the output side of the transformer. As an example, in a configuration in which the pulse power supply device 3 is used as the dielectric barrier discharge device 1 that generates plasma, it may be preferable to maintain the ringing wave for a certain period in addition to the pulse wave in order to improve the persistence of plasma discharge. In the first embodiment, the length of the ringing period Rx or the like can be arbitrarily adjusted by appropriately changing the length of the dead time DT2 or the like.

FIGS. 7 (a) and 7 (b) illustrate a configuration in which the length of the dead time DT2 is longer than that in the timing chart illustrated in FIG. 2 as a comparative example of the first embodiment. In the comparative example illustrated in FIG. 7(a), the dead time between State 1 and State 2 is denoted by a reference sign DT2A to be distinguished from the dead time DT2 in the first embodiment. That is, dead time DT2A according to the comparative example is longer than the dead time DT2 according to the first embodiment.

In the configuration of the comparative example, after State 1 ends in which the positive pulse wave Px is oscillated, the operation in State 2 is started after the dead time DT2A elapses. That is, after the switching elements SW1 to SW4 are turned off, the switching element SW5 is also in an off-state until the dead time DT2A elapses, and the electric vibration energy Er does not flow to the consumption circuit 13. Therefore, since the electric vibration energy Er is not consumed by the consumption circuit 13 during the dead time DT2A, the ringing wave Kx occurring after the pulse wave Px remains without being attenuated.

Then, in the comparative example, when the dead time DT2A elapses, the operation related to State 2 is started. That is, the switching element SW5 is switched to an on-state, the consumption of the electric vibration energy Er by the resistor R1 is started, and the ringing wave Kx is quickly attenuated. As a result, in the comparative example, as illustrated in FIG. 7(b), the length of the ringing period Rx occurring after the pulse wave Px becomes longer according to the length of the dead time DT2A as compared with the first embodiment illustrated in FIG. 2. Note that, in FIGS. 7(a) and 7(b), the length of the dead time DT2A is adjusted to such an extent that the ringing wave Rx for one round trip is maintained without being attenuated. In this way, by lengthening the ringing period Rx as necessary, only the ringing wave Kx necessary for maintaining the plasma discharge and the like can occur, while the ringing wave that hinders the high-frequency of the pulse wave can be quickly attenuated. Therefore, in the pulse power supply device 3, both the optimization of the pulse wave output and the higher-frequency of the pulse wave can be achieved.

In addition, in the pulse power supply device 3 according to the first embodiment, the consumption circuit 13 that consumes the electric vibration energy Er to attenuate the electric vibration is disposed on the primary side of the transformer 7. The voltage of the circuit on the secondary side of the transformer 7 (the output side of the transformer 7) using the parallel plate electrode 17 as an example is about several kV as an example and is higher than that of the circuit on the primary side of the transformer 7, which is about 200V as an example. Therefore, in a case where the circuit that attenuates electric vibration is disposed on the secondary side of the transformer 7, a component or the like that can withstand high voltage on the secondary side is required, and thus there is a concern that the cost of the pulse power supply device increases and the configuration becomes large and complicated.

On the other hand, in the first embodiment, the consumption circuit 13 is disposed on the primary side having relatively low voltage, so that a configuration can be realized in which the electric vibration is attenuated using a relatively inexpensive material. In addition, since the electric vibration transmitted from the primary side to the secondary side of the transformer 7 can be reduced by attenuating the electric vibration on the primary side, as a result, the electric vibration between the primary side and the secondary side can be quickly attenuated and disappear. Accordingly, by disposing the consumption circuit 13 in the circuit on the primary side of the transformer 7, it is possible to achieve both cost reduction of the pulse power supply device 3 and higher-frequency of the pulse wave.

In addition, in the first embodiment, the pulse generation circuit 9 that generates a pulse wave and the consumption circuit 13 that consumes the electric vibration energy Er are connected in parallel. That is, the resistor R1 is disposed in the consumption circuit 13, which is a circuit exclusively used for the consumption of electric vibration, and the pulse generation circuit 9 that generates a pulse wave is not provided with a configuration for the purpose of actively consuming the electric vibration energy Er, for example, the resistor R1. Therefore, in the case of oscillating the pulse wave Px or Py (State 1 or State 3), it is possible to avoid a situation in which the resistor R1 or the like obstructs the generation of the pulse wave and the output of the pulse wave is reduced. On the other hand, in a case where it is necessary to attenuate the ringing wave, the state transitions to State 2 or State 4 to switch the switching element SW5 to an on-state, and the consumption circuit 13 is activated to cause the resistor R1 to consume the electric vibration. Accordingly, in the pulse power supply device 3, it is possible to improve the attenuation efficiency of the electric vibration energy Er while improving the output efficiency of the pulse wave Px or the like.

### Second Embodiment

Next, a second embodiment of the present invention will be described. Note that the same components as those of the dielectric barrier discharge device 1 and the pulse power supply device 3 described in the first embodiment are denoted by the same reference signs, and configurations that are different components will be described in detail. A pulse power supply device 3A according to a second embodiment is different from the pulse power supply device 3 according to the first embodiment in that a consumption circuit 13A is provided instead of the consumption circuit 13. That is, the consumption circuit 13A according to the second embodiment will be mainly described while being compared with the consumption circuit 13 according to the first embodiment.

As illustrated in FIG. 8, the consumption circuit 13A according to the second embodiment includes a capacitor C1 in addition to the switching element SW5 and the resistor R1. The capacitor C1 is connected in parallel to the resistor R1. Then, each of the capacitor C1 and the resistor R1 is connected in series to the switching element SW5. The capacitor C1 accumulates the electric vibration energy Er generated after the oscillation of the pulse wave.

### <Operation of Second Embodiment>

Here, the operation of a dielectric barrier discharge device 1A including the pulse power supply device 3A according to the second embodiment will be described. In the dielectric barrier discharge device 1A according to the second embodiment, as illustrated in FIGS. 9 and 10, regarding the combination of the on/off states of the switching element SW1 to the switching element SW5, States 1 to 6 are repeated with the six states as one cycle. Hereinafter, the control operation of the switch controller 21 and the operation of the dielectric barrier discharge device 1A in each state will be described.

First, the operation in State 1 will be described. In State 1, similarly to the first embodiment, the switch controller 21 controls each of the switching elements SW1 to SW5 so that the switching element SW1 and the switching element SW4 are switched to an on-state, while the switching element SW2, the switching element SW3, and the switching element SW5 are switched to an off-state.

When the switching elements SW1 to SW5 are switched according to the combination mode of State 1, the consumption circuit 13A is electrically disconnected from the primary winding La, while the pulse generation circuit 9 is electrically connected to the primary winding La. Then, power is supplied from the power supply 11 to the pulse generation circuit 9, and the positive pulse voltage by a pulse wave is applied from the primary winding La to the secondary winding Lb. As a result, the plasma Pr due to the dielectric barrier discharge is generated in the parallel plate electrode 17 (see FIG. 4). When the positive pulse voltage is applied to the parallel plate electrode 17, electric vibration occurs between the parallel plate electrode 17 which is a capacitive load and the transformer 7.

Secondly, the operation in State 2 will be described. The switching operation in State 2 according to the second embodiment is similar to that in State 2 according to the first embodiment. That is, the switch controller 21 controls each of the switching elements SW1 to SW5 so that all of the four switching elements SW1 to SW4 disposed in the pulse generation circuit 9 are switched to an off-state, while the switching element SW5 disposed in the consumption circuit 13A is switched to an off-state. Then, ringing is attenuated by the operation in State 2.

FIG. 11 illustrates a flow of the electric vibration energy Er in State 2 of the second embodiment. When the switching elements SW1 to SW5 are switched according to the combination mode of State 2, the pulse generation circuit 9 is electrically disconnected from the primary winding La, while the primary winding La and the consumption circuit 13A are electrically connected. As a result, the electric vibration energy Er flows to the consumption circuit 13A.

The resistor R1 provided in the consumption circuit 13A consumes the electric vibration energy Er, but there is an upper limit to the electric vibration energy Er that can be consumed per unit time. Accordingly, when a large amount of electric vibration energy Er occurs and flows to the consumption circuit 13A, all the entire electric vibration energy Er may not be consumed by the resistor R1 in a short time.

Meanwhile, the capacitor C1 connected in parallel to the resistor R1 in the consumption circuit 13A has a very high electric vibration energy Er that can be accumulated per unit time. In other words, the upper limit of the energy accumulation efficiency of the capacitor C1 is much higher than the upper limit of the energy consumption efficiency of the resistor R1. Therefore, in the second embodiment, the portion that cannot be consumed by the resistor R1 among the electric vibration energy Er flowing to the consumption circuit 13A flows to the capacitor C1 and is rapidly accumulated. In other words, a part of the electric vibration energy Er (electric vibration energy Er1) is consumed in the resistor R1, and most of the remaining electric vibration energy Er (electric vibration energy Er2) is accumulated in the capacitor C1.

As described above, in the consumption circuit 13A according to the second embodiment, the consumption of the electric vibration energy Er by the resistor R1 and the accumulation of the electric vibration energy Er by the capacitor C1 are performed in parallel, so that the electric vibration energy Er can be more rapidly consumed or accumulated by the consumption circuit 13A as compared with the consumption circuit 13 of the first embodiment that performs only the consumption by the resistor R1. In other words, the consumption circuit 13A according to the second embodiment can rapidly process the electric vibration energy Er. As a result, in the second embodiment, the attenuation efficiency of the ringing wave Kx occurred due to the electric vibration can be further improved.

Note that, in the second embodiment, similarly to the first embodiment, the operation in State 2 is started after the dead time DT2 elapses after the generation of the positive pulse wave Px is completed in State 1. In addition, the length of the dead time DT2 can be arbitrarily changed. Therefore, similarly to the first embodiment, also in the second embodiment, the timing at which the attenuation of the ringing wave Kx is started can be arbitrarily adjusted.

In the second embodiment, as a result of the consumption by the resistor R1 and accumulation by the capacitor C1, all the electric vibration energy Er is consumed or accumulated by the consumption circuit 13A, so that the operation in State 2 is completed. That is, in the first embodiment including the consumption circuit 13, State 2 is not completed unless all the electric vibration energy Er is consumed by the resistor R1. On the other hand, in the second embodiment including the consumption circuit 13A, State 2 can be completed by temporarily accumulating all the remaining electric vibration energy Er in the capacitor C1 even if all the electric vibration energy Er cannot be consumed by the resistor R1. The length of the period during which State 2 is maintained can be arbitrarily set using the input unit or the like according to various conditions such as the amount of the electric vibration energy Er. The consumption time controller 23 controls the switch controller 21 to maintain State 2 according to the set time. When the electric vibration energy Er is consumed or accumulated by the consumption circuit 13A, the state transitions from State 2 to State 3. That is, when all the electric vibration energy Er occurring by the generation of the pulse wave related to State 1 is consumed or accumulated by the consumption circuit 13A, the state transitions from State 2 to State 3.

Thirdly, the operation in State 3 of the second embodiment will be described. State 3 of the second embodiment is a process that does not exist in the first embodiment. In State 3 in the second embodiment, all of the switching elements SW1 to SW5 are switched to an off-state. Since the switching elements SW1 to SW4 provided in the pulse generation circuit 9 are in an off-state, the pulse wave is not oscillated. In addition, since the switching element SW5 provided in the consumption circuit 13A is in an off-state, the electric vibration energy Er does not newly flow to the consumption circuit 13A.

However, in the consumption circuit 13A, a closed loop circuit is formed by the resistor R1 and the capacitor C1 connected in parallel, and the closed loop circuit is connected even when the switching element SW5 is in an off-state. In addition, when the switching element SW5 is in an off-state, the consumption circuit 13A is electrically disconnected from the pulse generation circuit **9.** Therefore, when State 3 is started, as illustrated in FIG. 12, the electric vibration energy Er2 accumulated in the capacitor C1 in State 2 flows to the resistor R1, and the energy Er2 is consumed in the resistor R1.

As described above, in the consumption circuit 13A according to the second embodiment, even in a state where the switching element SW5 is switched off, the electric vibration energy Er accumulated in the capacitor C1 can be continuously consumed by the resistor R1. The electric vibration energy continuously consumed in the consumption circuit 13A decreases over time corresponding to the time constant τ = CR. Note that, in the expression of the time constant τ = CR, C represents electrostatic capacitance (unit: F), and R represents electric resistance (unit: Ω). After State 3 is started, the state transitions to State 4 in proper timing.

Fourthly, the operation in State 4 of the second embodiment will be described. State 4 of the second embodiment is a process similar to State 3 of the first embodiment. That is, in State 4 of the second embodiment, the switch controller 21 controls each of the switching elements SW1 to SW5 so that the switching element SW2 and the switching element SW3 are switched to an on-state, while the switching element SW1, the switching element SW4, and the switching element SW5 are switched to an off-state.

When the switching elements SW1 to SW5 are switched according to the combination mode of State 4, power is supplied from the power supply 11 to the pulse generation circuit 9. Then, the current flows in a direction opposite to the reference sign F1 illustrated in FIG. 4 via the switching element SW3. That is, in State 4 of the second embodiment, the voltage having a polarity opposite to that of State 1 of the second embodiment is applied. As a result, the negative pulse voltage due to the pulse wave Py is applied from the primary winding La to the secondary winding Lb, and the dielectric barrier discharge is generated in the parallel plate electrode 17.

Note that, since the switching element SW5 is switched off in State 4 of the second embodiment, the consumption circuit 13A is electrically disconnected from each of the pulse generation circuit 9 and the primary winding La. Therefore, also in State 4, similarly to State 3, the electric vibration energy Er accumulated in the capacitor C1 can be continuously consumed by the resistor R1.

As a result of generating the dielectric barrier discharge in State 4, electric vibration is generated between the parallel plate electrode 17 and the transformer 7 similarly to State 1, so that the ringing wave Ky occurs after the negative pulse wave Py is generated. Therefore, after the operation in State 4 is performed, the ringing wave Ky is attenuated by the operation in State 5. As illustrated in FIG. 9, after the dead time DT4 elapses after the oscillation of the negative pulse wave Px is completed in State 4, the operation in State 5 is started. Similarly to the first embodiment, also in the second embodiment, the length of the dead time DT4 can be arbitrarily changed, and the timing at which the attenuation of the ringing wave Ky is started can be arbitrarily adjusted.

Fifthly, the operation in State 5 of the second embodiment will be described. The operation in State 5 of the second embodiment is similar to that in State 2 of the second embodiment. That is, in State 5 of the second embodiment, the switch controller 21 controls each of the switching elements SW1 to SW5 so that all of the four switching elements SW1 to SW4 disposed in the pulse generation circuit 9 are switched to an off-state, while the switching element SW5 disposed in the consumption circuit 13 is switched to an on-state.

When the switching elements SW1 to SW5 are switched according to the combination mode of State 5, the primary winding La and the consumption circuit 13 are electrically connected, and the electric vibration energy Er flows to the consumption circuit 13A (see FIG. 5). Then, similarly to State 2, in the consumption circuit 13A, the partial electric vibration energy Er1 is consumed by the resistor R1, and the remaining electric vibration energy Er2 is accumulated in the capacitor C1. As a result, all the electric vibration energy Er occurring by State 4 is quickly consumed or accumulated by the consumption circuit 13A, and the electric vibration quickly disappears on the primary side. Therefore, since the electric vibration is not transmitted to the secondary side of the transformer 7, the ringing wave Ky occurring after the negative pulse wave Py is generated in State 4 is rapidly attenuated by the operation in State 5. Accordingly, the ringing period Ry after the negative pulse wave Py is generated in State 4 can also be significantly shortened. When the electric vibration energy Er generated by State 4 is consumed or accumulated by the consumption circuit 13A, the state transitions from State 5 to State 6.

Sixthly, the operation in State 6 of the second embodiment will be described. The operation in State 6 of the second embodiment is similar to that in State 3 of the second embodiment. That is, in State 6 of the second embodiment, all of the switching elements SW1 to SW5 are switched to an off-state. In State 6, by turning off the switching element SW5, the consumption circuit 13A is electrically disconnected from the pulse generation circuit 9. As a result, the electric vibration energy Er2 accumulated in the capacitor C1 in State 5 flows to the resistor R1, and the electric vibration energy Er2 is consumed in the resistor R1 (see FIG.12).

The operation in State 6 is completed, so that a series of operations with States 1 to 6 as one cycle is completed. Thereafter, the state returns to State 1 from State 6, and a series of operations including States 1 to 6 is appropriately repeated to execute plasma processing by the dielectric barrier discharge.

### <Effects of Configuration of Second Embodiment>

In the pulse power supply device 3A according to the second embodiment, the frequency of the pulse signal can be further improved by disposing the consumption circuit 13A in parallel with the pulse generation circuit 9. The consumption circuit 13A includes the capacitor C1 in addition to the resistor R1, and the resistor R1 and the capacitor C1 are connected in parallel. Therefore, in the consumption circuit 13A, the remaining electric vibration energy Er is temporarily accumulated in the capacitor C1 while a part of the electric vibration energy Er is consumed by the resistor R1, so that the electric vibration occurring by the oscillation of the pulse wave Px or Py can be more rapidly eliminated. Therefore, in the configuration of the second embodiment including the consumption circuit 13A, since the ringing periods Rx and Ry can be shortened as compared with the first embodiment, the frequency of the pulse signal can be further improved.

In addition, the consumption circuit 13A is electrically disconnected from the pulse generation circuit 9 by switching the switching element SW5 to off. Therefore, by turning off the switching element SW5, the electric vibration energy Er temporarily accumulated in the capacitor C1 can be consumed by the resistor R1. That is, not only in a state where all the switching elements SW1 to SW5 are in off-state (State 3 or State 6), but also in a state where the switching element SW5 is in off and the pulse generation circuit 9 is connected to the primary winding La and oscillates a pulse wave (State 1 or State 4), the electric vibration energy Er accumulated in the capacitor C1 can be consumed by the resistor R1. In other words, the electric vibration energy Er occurring when the previous pulse wave is generated can be consumed by the consumption circuit 13A in parallel with the operation of the newly generated pulse wave by the pulse generation circuit 9. Such an operation is executed by the switch controller 21 switching the switching element SW5 of the consumption circuit 13A to an off-state and switching at least one of the switching elements SW1 to SW4 to an on-state in a state where the electric vibration energy Er is accumulated in the capacitor C1.

As a specific example, a case will be described in which the switching elements SW2 and SW3 are switched on in a state where the electric vibration energy Er2 accumulated in the capacitor C1 is consumed by the resistor R1 in State 3 of the second embodiment, and the state transitions to State 4. In this case, as illustrated in FIG. 13, in the consumption circuit 13A, the operation of consuming the electric vibration energy Er2 accumulated in the capacitor C1 by the resistor R1 is performed continuously from State 2. On the other hand, in the pulse generation circuit 9, the current flows in a direction indicated by a reference sign F2 via the switching element SW3, the negative pulse wave Py is oscillated, and the plasma Pr is generated in the discharger 5.

That is, in the second embodiment, while the negative pulse wave Py is generated in State 4, the electric vibration energy Er2 previously occurring at the time of generating the positive pulse wave Px and accumulated in the capacitor C1 can be consumed by the resistor R1. In other words, in the configuration of the second embodiment, in a case where the electric vibration energy Er2 is accumulated in the capacitor C1, the energy accumulated in the capacitor C1 can be consumed by the resistor R1 even in a state where the switching element SW5 is turned off. Then, when the switching element SW5 is turned off, the consumption circuit 13A is electrically separated from the pulse generation circuit 9. Therefore, until the switching element is turned on next time, the pulse generation circuit 9 is operated, and the electric vibration energy Er2 can be consumed by the resistor R1 while generating the pulse wave.

Therefore, in the period from the start of State 2 to the start of State 5 indicated by a reference sign M1 in FIG. 9, if the electric vibration energy Er occurring after State 1 is consumed by the resistor R1 of the consumption circuit 13A, the operation of the pulse power supply device 3A is not hindered. Similarly, the electric vibration energy Er occurring after State 4 can be consumed by the consumption circuit 13A in a period from the start time of State 5 to the end time of the next State 2. That is, when power can be accumulated by the capacitor C1 and the consumption circuit 13A in which the capacitor C1 and the resistor R1 are connected is provided, the switching element of the pulse generation circuit 9 is switched to an on-state while the switching element SW5 is switched to an off-state in a state where the electric vibration energy Er is accumulated in the capacitor C1, so that the electric vibration energy Er accumulated in the capacitor C1 in the consumption circuit 13A can be consumed by the resistor R1 while the pulse wave is generated from the pulse generation circuit **9.** As a result, the consumable time of the electric vibration energy Er can be secured longer, and thus it is also possible to further increase the frequency of the pulse wave.

Note that, since the capacitor C1 is not provided in the first embodiment including the consumption circuit 13, the electric vibration energy Er can be consumed by the resistor R1 only during the period in which the switching element SW5 is in an on-state (only during the period of State 2 or State 4). Therefore, in the first embodiment, it is necessary to maintain State 2 (turn on the switching element SW5) until the consumption of the electric vibration energy Er by the resistor R1 is completed. When any of the switching elements SW1 to SW4 is turned on to operate the pulse generation circuit 9 while the switching element SW5 is turned on to consume the electric vibration energy Er, a voltage drop occurs due to the presence of the resistor R1, and a sufficient voltage is not applied to the transformer 7, so that desired voltage cannot be obtained on the secondary side of the transformer 7.

On the other hand, in the second embodiment including the consumption circuit 13A, in State 3 in which all the switching elements SW are turned off, the state can transition to State 4 at any timing and the next pulse wave can be oscillated. Similarly, the state can transition to the next State 1 at any timing in State 6. As a result, the interval F between the pulse wave Px oscillated in State 1 and the pulse wave Py oscillated in State 4 can be further shortened, so that the pulse wave can have a higher frequency in the pulse power supply device 3A. In addition, in the second embodiment, since the period during which the switching element SW5 is maintained in an on-state can be shortened as compared with the first embodiment, it is possible to avoid a burden on the switching element SW5. Furthermore, depending on the object to be processed, the optimum plasma may be obtained by adding the component of the ringing wave to the pulse wave. In this case, since the consumption circuit 13A consumes the energy when the switching element SW5 is off, the timing of the dead time can be easily controlled as compared with the consumption circuit 13 according to the first embodiment.

### Third Embodiment

Next, a third embodiment of the present invention will be described. FIG. 14 is a diagram illustrating a configuration of a dielectric barrier discharge device 1B including a pulse power supply device 3B according to the third embodiment. The pulse power supply device 3B according to the third embodiment is different from the pulse power supply device 3 according to the first embodiment in that a consumption circuit 13B is provided instead of the consumption circuit 13.

As illustrated in FIG. 14, the consumption circuit 13B according to the third embodiment includes a converter 25 in addition to the switching element SW5, the resistor R1, and the capacitor C1. The converter 25 functions as a regenerative circuit that regenerates the electric vibration energy Er accumulated in the capacitor C1. That is, the consumption circuit 13B according to the third embodiment includes a regenerative circuit including the converter 25 in addition to the consumption circuit 13A according to the second embodiment.

In the consumption circuit 13B according to the third embodiment, the capacitor C1 is connected in parallel to the resistor R1. Then, each of the capacitor C1 and the resistor R1 is connected in series to the switching element SW5. The converter 25 is attached to both ends of the capacitor C1. The + side of the output of the converter 25 is connected to the + side of the power supply 11, and the ground side of the converter 25 is connected to the ground side of the power supply 11.

The operation of the dielectric barrier discharge device 1B according to the third embodiment is basically common to the operation of the second embodiment illustrated in FIGS. 9 and 10. However, the third embodiment is different from the second embodiment in terms of processing of the electric vibration energy Er in State 3.

In the third embodiment, similarly to the second embodiment, the pulse generation circuit 9 generates the positive pulse wave Px in State 1. When the state transitions to State 2 and the switching element SW5 is switched on after the positive pulse wave Px is generated, the electric vibration energy Er occurring by the generation of the positive pulse wave Px flows to the consumption circuit 13B. Then, the partial electric vibration energy Er1 is consumed by the resistor R1, and the remaining electric vibration energy Er2 is accumulated in the capacitor C1. As a result, the ringing wave Kx generated after the generation of the positive pulse wave Px is quickly attenuated. When all the electric vibration energy Er is consumed or accumulated in the consumption circuit 13B, the state transitions to State 3.

When transitioning to State 3, the switch controller 21 switches all the switching elements SW1 to SW5 to an off-state. When the switching element SW5 is turned off, the electric vibration energy Er2 accumulated in the capacitor C1 is regenerated to the power supply 11 by the converter 25. The regenerated electric vibration energy Er2 is reused as power for generating the plasma Pr in the subsequent State 4 or State 1.

The operation of regenerating the electric vibration energy Er2 is similarly performed in State 6 of the third embodiment. In the third embodiment, the converter 25 is used as a configuration for regenerating the electric vibration energy Er, but the present invention is not limited thereto, and an appropriate material may be used as long as it is a circuit configuration for regenerating the electric vibration energy Er.

In the second embodiment, the electric vibration energy Er2 accumulated in the capacitor C1 in State 2 is consumed by the resistor R1 in State 3. On the other hand, in the third embodiment, the electric vibration energy Er2 accumulated in the capacitor C1 in State 2 is regenerated and reused in State 3. Therefore, the energy efficiency of the pulse power supply device 3B according to the third embodiment can be improved.

### Fourth Embodiment

Next, a fourth embodiment of the present invention will be described. FIG. 15 is a diagram illustrating a configuration of a dielectric barrier discharge device 1C including a pulse power supply device 3C according to the fourth embodiment. The pulse power supply device 3C according to the fourth embodiment is different from the pulse power supply device 3 according to the first embodiment in that a consumption circuit 13C is provided instead of the consumption circuit 13.

The consumption circuit 13C according to the fourth embodiment includes consumption circuits having a switching element, a resistor, and a capacitor, that is, a plurality of circuits corresponding to the consumption circuits 13A. FIG. 15 illustrates the consumption circuit 13C including two sets of the consumption circuits 13A. One of the two sets of the consumption circuits 13A is defined as a consumption circuit 13Ap, and the other is defined as a consumption circuit 13As to distinguish between these consumption circuits. In the consumption circuit 13C, the consumption circuit 13Ap and the consumption circuit 13As are connected in parallel. Note that, the number of consumption circuits 13A included in the consumption circuit 13C is not limited to two, and may be three or more.

Among the two consumption circuits 13A included in the consumption circuit 13C, the consumption circuit 13Ap includes the switching element SW5, the resistor R1, and the capacitor C1. The consumption circuit 13As includes the switching element SW6, a resistor R2, and a capacitor C2. Similarly to the second embodiment, the consumption circuit 13Ap is a circuit in which the switching element SW5 is connected in series to the resistor R1 and the capacitor C1 connected in parallel. The consumption circuit 13Ap is a circuit in which the switching element SW6 is connected in series to the resistor R2 and the capacitor C2 connected in parallel. As described later, in the fourth embodiment, one consumption circuit 13Ap is used to attenuate the ringing wave Kx occurring after oscillation of the positive pulse wave Px, and the other consumption circuit 13As is used to attenuate the ringing wave Ky occurring after oscillation of the negative pulse wave Py. In the fourth embodiment, the switching element SW5 and the switching element SW6 correspond to the resistance switching element according to the present invention.

### <Operation of Fourth Embodiment>

Here, the operation of the dielectric barrier discharge device 1C including the pulse power supply device 3C according to the fourth embodiment will be described. In the dielectric barrier discharge device 1C according to the fourth embodiment, as illustrated in FIGS. 16 and 17, regarding the combination of the on/off states of the switching element SW1 to the switching element SW6, States 1 to 6 are repeated with the six states as one cycle. Hereinafter, the control operation of the switch controller 21 and the operation of the dielectric barrier discharge device 1A in each state will be described.

First, the operation in State 1 will be described. In State 1, the switch controller 21 controls each of the switching elements SW1 to SW6 so that the switching element SW1 and the switching element SW4 are switched to an on-state, while the switching element SW2, the switching element SW3, the switching element SW5, and the switching element SW6 are switched to an off-state. Since each of the switching elements SW5 and SW6 is in an off-state, the consumption circuit 13C is electrically disconnected from the primary winding La.

When the switching elements SW1 to SW6 are switched according to the combination mode of State 1, power is supplied from the power supply 11 to the pulse generation circuit 9, the positive pulse voltage by the positive pulse wave Px is applied from the primary winding La to the secondary winding Lb, and the plasma Pr by the dielectric barrier discharge is generated in the parallel plate electrode 17 (see FIG. 4). When the positive pulse voltage is applied to the parallel plate electrode 17, electric vibration is generated between the parallel plate electrode 17 which is a capacitive load and the transformer 7. Since the ringing wave Kx occurs after the oscillation of the positive pulse wave Px due to the electrical vibration, the operation of attenuating the ringing wave Kx by State 2 is performed.

Secondly, the operation in State 2 will be described. In State 2 of the fourth embodiment, all the four switching elements SW1 to SW4 disposed in the pulse generation circuit 9 are switched to an off-state. In addition, in the consumption circuit 13C, the switching element SW5 disposed in the consumption circuit 13Ap is switched to an on-state, while the switching element SW6 disposed in the consumption circuit 13As is switched to an off-state. After switching the switching elements SW1 and SW4 to an off-state to end State 1, the switch controller 21 switches the switching element SW5 to an on-state after a predetermined dead time DT2 is elapsed, to start State 2. Then, the ringing wave Kx occurring after the generation of the positive pulse wave Px is attenuated by the operation in State 2.

When the switching elements SW1 to SW6 are switched according to the combination mode of State 2, a portion of the consumption circuit 13Ap in the consumption circuit 13C is electrically connected to the primary winding La. As a result, as illustrated in FIG. 18, the electric vibration energy Er flows to the consumption circuit 13C, and flows to the consumption circuit 13Ap having the switching element SW5 which is in an on-state.

The electric vibration energy Er flowing to the consumption circuit 13Ap is consumed or accumulated by the resistor R1 and the capacitor C1 similarly to the second embodiment. That is, the partial electric vibration energy Er1 is consumed by the resistor R1, and the remaining electric vibration energy Er2 is accumulated in the capacitor C1 in parallel. As a result of the electric vibration energy Er being quickly consumed or accumulated by the consumption circuit 13Ap, the ringing wave Kx occurring after the generation of the positive pulse wave Px is rapidly attenuated by the operation in State 2 and disappears. When all the electric vibration energy Er generated after State 1 is consumed or accumulated by the consumption circuit 13Ap, the state transitions from State 2 to State 3.

Thirdly, the operation in State 3 will be described. The operation in State 3 of the fourth embodiment is basically common to that in State 3 of the second embodiment. In State 3 of the fourth embodiment, all of the switching elements SW1 to SW6 are switched to an off-state. Since all of the switching elements SW1 to SW4 provided in the pulse generation circuit 9 are in an off-state, no pulse wave is generated. Then, by switching the switching element SW5 to an off-state in the consumption circuit 13C, the closed loop circuit including the resistor R1 and the capacitor C1 is electrically disconnected from each of the pulse generation circuit 9 and the primary winding La. Therefore, when State 3 is started, the electric vibration energy Er2 accumulated in the capacitor C1 in State 2 flows to the resistor R1, and the energy Er2 is consumed in the resistor R1 (see FIG. 12).

As described above, in State 3 of the fourth embodiment, similarly to State 3 of the second embodiment, the electric vibration energy Er corresponding to the amount accumulated in the capacitor C1 is continuously consumed by the resistor R1 in a state where the switching element SW5 is switched off. That is, in State 2, most of the electric vibration energy Er is accumulated using the capacitor C1 and the electric vibration energy Er rapidly is eliminated from the pulse generation circuit 9. Then, the consumption circuit 13Ap in which the electric vibration energy Er is accumulated is electrically disconnected from the pulse generation circuit 9 in State 3, and the electric vibration energy Er is continuously consumed in the consumption circuit 13Ap. The electric vibration energy continuously consumed in the consumption circuit 13Ap decreases over time corresponding to the time constant τ = CR. By electrically disconnecting the consumption circuit 13Ap from the pulse generation circuit 9 that generates a pulse wave, it is possible to transition to State 4 in proper timing and start the generation of the negative pulse wave Py.

Fourthly, the operation in State 4 will be described. In State 4, the switch controller 21 controls each of the switching elements SW1 to SW6 so that the switching element SW2 and the switching element SW3 are switched to an on-state, while the switching element SW1, the switching element SW4, the switching element SW5, and the switching element SW6 are switched to an off-state.

When the switching elements SW1 to SW6 are switched according to the combination mode of State 4, power is supplied from the power supply 11 to the pulse generation circuit 9. Then, the current flows in a direction opposite to the reference sign F1 illustrated in FIG. 4 via the switching element SW3. As a result, the negative pulse voltage due to the negative pulse wave Py is applied from the primary winding La to the secondary winding Lb, and the dielectric barrier discharge occurs in the parallel plate electrode 17.

Note that, since the switching element SW5 is switched off in State 4 of the fourth embodiment, similarly to State 4 of the second embodiment, the consumption circuit 13Ap is electrically disconnected from the pulse generation circuit 9. Therefore, also in State 4, similarly to State 3, the electric vibration energy Er2 accumulated in the capacitor C1 can be continuously consumed by the resistor R1.

When the negative pulse voltage is applied to the parallel plate electrode 17 in State 4, electric vibration occurs between the parallel plate electrode 17 which is a capacitive load and the transformer 7. Since the ringing wave Ky occurs after the oscillation of the negative pulse wave Py due to the electrical vibration, the state transitions to State 5 and the operation of attenuating the ringing wave Ky is performed.

Fifthly, the operation in State 5 of the fourth embodiment will be described. In State 5 of the fourth embodiment, all of the four switching elements SW1 to SW4 disposed in the pulse generation circuit 9 are switched to an off-state. In addition, in the consumption circuit 13C, the switching element SW5 disposed in the consumption circuit 13Ap is switched to an off-state, while the switching element SW6 disposed in the consumption circuit 13As is switched to an on-state. After switching the switching elements SW2 and SW3 to an off-state to end State 4, the switch controller 21 switches the switching element SW6 to an on-state after a predetermined dead time DT4 is elapsed, to start State 5. Then, the ringing wave Ky occurring after the generation of the negative pulse wave Py is attenuated by the operation in State 5.

When the switching elements SW1 to SW6 are switched according to the combination mode of State 5, a portion of the consumption circuit 13As in the consumption circuit 13C is electrically connected to the primary winding La. As a result, as illustrated in FIG. 19, the electric vibration energy Er flows to the consumption circuit 13C, and flows to the consumption circuit 13As having the switching element SW6 which is in an on-state.

The electric vibration energy Er flowing to the consumption circuit 13As is eliminated by the resistor R2 and the capacitor C2 provided in the consumption circuit 13As. That is, the partial electric vibration energy Er1 is consumed by the resistor R2, and the remaining electric vibration energy Er2 is accumulated in the capacitor C2 in parallel. As a result of the quick disappearance of the electric vibration energy Er by the consumption circuit 13As, the ringing wave Ky occurring after the oscillation of the negative pulse wave Py is rapidly attenuated by the operation in State 5 and disappears. When all the electric vibration energy Er occurring after State 4 is consumed or accumulated by the consumption circuit 13Ap, the state transitions from State 5 to State 6.

Sixthly, operation in State 6 will be described. In State 6 of the fourth embodiment, similarly to State 3 of the fourth embodiment, all of the switching elements SW1 to SW6 are switched to an off-state. Since the switching elements SW1 to SW4 provided in the pulse generation circuit 9 are in an off-state, the pulse wave is not oscillated. Then, by switching the switching element SW6 to an off-state in the consumption circuit 13C, the closed loop circuit including the resistor R2 and the capacitor C2 is electrically disconnected from the main pulse generation circuit 9. Therefore, when State 6 is started, the electric vibration energy Er2 accumulated in the capacitor C2 in State 5 flows to the resistor R2, and the energy Er2 is consumed in the resistor R2.

As described above, in State 6 of the fourth embodiment, in a state where the switching element SW6 is switched off, the electric vibration energy Er corresponding to the amount accumulated in the capacitor C2 is continuously consumed by the resistor R2. That is, in State 5, most of the electric vibration energy Er is accumulated using the capacitor C2, and the electric vibration energy Er rapidly is eliminated from the pulse deriving circuit 9. Then, the consumption circuit 13As in which the electric vibration energy Er is accumulated is electrically disconnected from the pulse generation circuit 9 in State 6, and the electric vibration energy Er is continuously consumed in the consumption circuit 13As.

By electrically disconnecting the consumption circuit 13As from the pulse generation circuit 9 that generates a pulse wave, it is possible to transition from State 6 to State 1 in proper timing and start the oscillation of the positive pulse wave Px again. Hereinafter, plasma processing by the dielectric barrier discharge is executed by appropriately repeating a series of operations with States 1 to 6 as one cycle.

### <Effects of Configuration of Fourth Embodiment>

The pulse power supply device 3C according to the fourth embodiment includes the consumption circuit 13C having a plurality of consumption circuits 13A. Then, when the electric vibration energy Er occurring after the generation of the pulse wave is consumed, the plurality of consumption circuits 13A is selectively used according to the pulse wave generation conditions or the like. In the fourth embodiment, as illustrated in FIGS. 16 and 17 as an example, when the electric vibration energy Er occurring by the generation of the positive pulse wave Px is consumed, the consumption circuit 13Ap is used (State 1 to 3). On the other hand, when the electric vibration energy Er occurring by the generation of the negative pulse wave Py is consumed, the consumption circuit 13As is used (State 4 to 6). In other words, the consumption circuit 13Ap of the consumption circuit 13C is used to attenuate the ringing wave Kx, and the consumption circuit 13As of the consumption circuit 13C is used to attenuate the ringing wave Ky.

As described above, by providing the plurality of consumption circuits 13A and alternating the consumption circuit 13A used to consume the electric vibration energy Er every time the pulse wave is generated, it is possible to process the larger electric vibration energy Er. That is, the switching element SW5 turned on in State 2 is switched to an off-state after all the electric vibration energy Er generated after State 1 is accumulated in the capacitor C1 (State 3). Thereafter, until State 2 is started again, the switching element SW5 is in off-state, and the consumption circuit 13Ap is electrically disconnected from the pulse generation circuit 9.

Therefore, if the electric vibration energy Er occurring after State 1 is consumed by the resistor R1 of the consumption circuit 13Ap in the period from the start of State 2 to the start of the next State 2 indicated by the reference sign M2 in FIG. 16, the operation of the pulse power supply device 3C is not hindered. That is, when the plurality of consumption circuits 13A is provided, the consumable time of the electric vibration energy Er can be secured for a longer time, so that the larger electric vibration energy Er can be processed by the consumption circuit 13C. As a result, it is also possible to further increase the frequency of the pulse wave.

In addition, in the fourth embodiment including the consumption circuit 13C, in State 3 in which all of the switching elements are switched off, it is possible to transition to State 4 at any timing and oscillate the next pulse wave. Similarly, the state can transition to the next State 1 at any timing in State 6. As a result, the interval F between the pulse wave Px oscillated in State 1 and the pulse wave Py oscillated in State 4 can be further shortened, so that the pulse wave can have a higher frequency in the pulse power supply device 3C. In addition, in the fourth embodiment, since the pluralities of switching elements SW5 and SW6 are included, the period during which the switching element included in the consumption circuit 13C is maintained in on-state can be further shortened and the number of times of turning on is also reduced as compared with the consumption circuit 13A of the second embodiment including one switching element SW5, so that the load on the switching elements SW5 and the switching elements SW6 included in the consumption circuit 13C can be further reduced. Furthermore, depending on the object to be processed, the optimum plasma may be obtained by adding the component of the ringing wave to the pulse wave. In this case, since the consumption circuit 13C consumes the electric vibration energy Er when the switching elements SW5 and SW6 are turned off, the timing of the dead time can be more easily controlled as compared with the consumption circuit 13A according to the second embodiment.

Note that, in the configuration of the fourth embodiment including the plurality of consumption circuits 13A, the ringing can be suitably attenuated in response to more various types of impedance. That is, by making the resistance value of the resistor R1 and the resistance value of the resistor R2 different or making the capacitance value of the capacitor C1 and the capacitance value of the capacitor C2 different, the characteristics of the consumption circuit 13Ap and the consumption circuit 13As are different. By making the characteristics of the plurality of consumption circuits 13A different in this manner, as an example, when the frequency of the electric vibration changes, the ringing wave can be attenuated by selectively using the consumption circuit 13A corresponding to the changed impedance.

As an example, when the consumption circuit 13Ap is a condition more suitable for attenuation of the ringing wave, the switching elements SW1 to SW6 are switched in the combination mode of State 2 after the generation of the pulse wave is completed. That is, only the switching element SW5 is switched to an on-state. In addition, when the consumption circuit 13As is a condition more suitable for attenuation of the ringing wave, the switching elements SW1 to SW6 are switched in the combination mode of State 5 after the generation of the pulse wave is completed. That is, only the switching element SW6 is switched to the on state. The versatility of the pulse power supply device 3C can be further improved by selectively using a suitable one among the plurality of consumption circuits 13A having different characteristics as described above.

### Fifth Embodiment

Next, a fifth embodiment of the present invention will be described. FIG. 20 is a diagram illustrating a configuration of a dielectric barrier discharge device 1D including a pulse power supply device 3D according to the fifth embodiment. The pulse power supply device 3D according to the fifth embodiment is different from the pulse power supply device 3 according to the first embodiment in that a transformer 7D includes a tertiary winding Lc in addition to the primary winding La and the secondary winding Lb.

The tertiary winding Lc included in the transformer 7D is electrically insulated from each of the primary winding La and the secondary winding Lb. Then, the consumption circuit 13 including the resistor R1 and the switching element SW5 connected in series is connected in parallel to the tertiary winding Lc. That is, the fifth embodiment is different from the first embodiment in which the consumption circuit 13 is disposed on the primary side of the transformer 7 in that the consumption circuit 13 is disposed on the tertiary side of the transformer 7D.

### <Operation of Fifth Embodiment>

The operation of the dielectric barrier discharge device 1D according to the fifth embodiment is common to the operation of the dielectric barrier discharge device 1 according to the first embodiment. That is, the combination of the on/off states of the switching elements SW1 to SW5 in the fifth embodiment is as illustrated in FIGS. 2 and 3, and States 1 to 4 are repeated with the four states as one cycle.

First, when the switching element SW1 and the switching element SW4 are switched to an on-state in State 1, the pulse generation circuit 9 and the primary winding La are electrically connected. In addition, when switching element SW5 is turned off, the consumption circuit 13 is electrically disconnected from the tertiary winding Lc. Then, the positive pulse wave Px is generated in the pulse generation circuit 9 disposed on the primary side of the transformer 7, and positive pulse voltage is applied to the parallel plate electrode 17 to generate the dielectric barrier discharge.

Even after the dielectric barrier discharge is stopped, the energy corresponding to (1/2) ·CV² is accumulated in the parallel plate electrode 17, and the energy resonates between the parallel plate electrode 17 and the transformer 7D and electric vibration occurs. Since the primary winding La, the secondary winding Lb and the tertiary winding Lc are electromagnetically coupled, the electric vibration is transmitted from the secondary side to each of the primary side and the tertiary side (consumption circuit 13 side) via the transformer 7D. The electrical vibration causes the occurrence of the ringing wave Kx after the generation of the pulse wave Px. Therefore, in the pulse power supply device 3D according to the fifth embodiment, the ringing wave Kx is attenuated by the operation in State 2.

Secondly, the operation in State 2 will be described. In State 2, the switch controller 21 controls each of the switching elements SW1 to SW5 so that all of the four switching elements SW1 to SW4 disposed in the pulse generation circuit 9 are switched to an off-state, while the switching element SW5 disposed in the consumption circuit 13 is switched to an on-state.

When the switching elements SW1 to SW5 are switched according to the combination mode of State 2, the primary winding La and the pulse generation circuit 9 are electrically disconnected, while the tertiary winding Lc and the consumption circuit 13 are electrically connected. As a result, as illustrated in FIG. 21, the electric vibration energy Er flows to the consumption circuit 13 disposed on the tertiary side, and the electric vibration energy Er is quickly consumed in the resistor R1 provided in the consumption circuit 13. The energy is consumed in the resistor R1, so that the electric vibration energy Er quickly disappears on the tertiary side. In this case, since the primary winding La, the secondary winding Lb, and the tertiary winding Lc are electromagnetically coupled, the electric vibration energy Er is not transmitted from the tertiary side to the secondary side. As a result, by disposing the resistor R1 on the tertiary side, the electric vibration energy Er quickly disappears also on the secondary side. Therefore, the ringing wave Kx occurring after the positive pulse wave Px is generated in State 1 is rapidly attenuated and disappears by the operation in State **2.** The ringing wave Kx disappears, so that the state transitions from State 2 to State 3.

Thirdly, the operation in State 3 will be described. In State 3, by switching the switching element SW5 to an off-state, the consumption circuit 13 is electrically disconnected from the tertiary winding Lc. Then, when the switching element SW2 and the switching element SW3 are switched to an on-state, the negative pulse wave Py is generated in the pulse generation circuit 9 disposed on the primary side of the transformer 7D, and negative pulse voltage is applied to the parallel plate electrode 17 to generate the dielectric barrier discharge. Since the primary winding La, the secondary winding Lb, and the tertiary winding Lc are electromagnetically coupled, after the generation of the negative pulse wave Py, electric vibration is generated similarly to State 1, and is transmitted from the secondary side to each of the primary side and the tertiary side via the transformer 7D. The electrical vibration causes the occurrence of the ringing wave Ky after the generation of the negative pulse wave Py. Therefore, when the negative pulse wave Py is generated in State 3, the state transitions to State 4 and the ringing wave Ky is attenuated.

Fourthly, the operation in State 4 will be described. In State 4, the switch controller 21 controls each of the switching elements SW1 to SW5 so that all of the four switching elements SW1 to SW4 disposed in the pulse generation circuit 9 are switched to an off-state, while the switching element SW5 disposed in the consumption circuit 13 is switched to an on-state. That is, the mode of the switch control in State 4 is the same as the mode of the switch control in State 2.

When the switching elements SW1 to SW5 are switched according to the combination mode of State 4, the tertiary winding Lc and the consumption circuit 13 are electrically connected again. As a result, as illustrated in FIG. 21, the electric vibration energy Er flows to the consumption circuit 13, and the electric vibration energy Er is quickly consumed in the resistor R1. Therefore, the ringing wave Ky occurring after the negative pulse wave Py is generated in State 3 is rapidly attenuated and disappears by the operation in State 4. Accordingly, the ringing period Ry after the negative pulse wave Py is generated in State 3 can also be significantly shortened.

The operation in State 4 is completed, so that a series of operations with States 1 to 4 as one cycle is completed. Thereafter, the state returns to State 1 from State 4, and a series of operations including States 1 to 4 is appropriately repeated to execute plasma processing by the dielectric barrier discharge.

### <Effects of Configuration of Fifth Embodiment>

In the pulse power supply device 3D according to the fifth embodiment, the tertiary winding Lc is further disposed in the transformer 7D in addition to the primary winding La and the secondary winding Lb, and the consumption circuit 13 is connected to the tertiary winding Lc. When the pulse generation circuit 9 connected to the primary winding La of the transformer 7D generates a pulse wave, plasma discharge is generated in the parallel plate electrode 17 connected to the secondary winding Lb of the transformer 7D. Although electric vibration occurs by the discharge and transmitted from the secondary side to the tertiary side of the transformer 7D, the energy Er of the electric vibration is consumed by the consumption circuit 13.

Since the primary winding La, the secondary winding Lb, and the tertiary winding Lc are electromagnetically coupled, when the electric vibration energy Er is consumed on the tertiary side, the electric vibration on the primary side and the secondary side of the transformer 7D is also attenuated. As a result, the ringing is quickly attenuated also on the primary side and the secondary side. That is, the electric vibration energy Er is consumed on the tertiary side of the transformer 7D, so that, similarly to the first embodiment, the ringing wave Kx or Ky can be quickly attenuated. In addition, when the switch controller 21 and the consumption time controller 23 are provided, the lengths of the dead times DT2 and DT4 can be arbitrarily controlled, so that the lengths of the ringing periods Rx and Ry can be arbitrarily adjusted.

Then, the tertiary winding Lc is electrically insulated from each of the primary winding La and the secondary winding Lb. That is, the consumption circuit 13 is electrically insulated from the pulse generation circuit 9 that generates a pulse wave. Therefore, since the ground can be installed at any place in the tertiary winding Lc including the consumption circuit 13, the operation of the consumption circuit 13 can be further stabilized. Accordingly, the occurrence of the malfunction in the pulse power supply device 3D can be more reliably prevented.

### <Other Embodiments>

Note that, the embodiments disclosed herein are illustrative in all respects and are not restrictive. The scope of the present invention includes the claims and all modifications within the meaning and scope equivalent to the claims. As an example, the present invention can be modified as follows.

(1) The configuration in which the consumption circuit is disposed on the tertiary side of the transformer 7D according to the fifth embodiment can be applied not only to the first embodiment but also to the second to fourth embodiments. FIG. 22 is a diagram illustrating a configuration of a first modification in which the transformer 7D of the fifth embodiment is applied to the second embodiment. FIG. 23 is a diagram illustrating a configuration of a second modification in which the transformer 7D of the fifth embodiment is applied to the third embodiment. FIG. 24 is a diagram illustrating a configuration of a third modification in which the transformer 7D of the fifth embodiment is applied to the fourth embodiment.

In a pulse power supply device 3E according to the first modification illustrated in FIG. 22, the consumption circuit 13A is connected to the tertiary winding Lc of the transformer 7D. Similarly to the second embodiment, the consumption circuit 13A includes the resistor R1 and the capacitor C1 connected in series, and the switching element SW5 connected in parallel to each of the resistors R1 and the capacitor C1. The operation of a dielectric barrier discharge device 1E including the pulse power supply device 3E according to the first modification is common to that of the second embodiment. That is, the combination of the on/off states of the switching elements SW1 to SW5 in the first modification is as illustrated in FIGS. 9 and 10, and States 1 to 6 are repeated with the six states as one cycle.

In the first modification, by applying the configuration such as the transformer 7D according to the fifth embodiment to the configuration of the second embodiment, it is possible to obtain both the effects of the second embodiment and the effects of the fifth embodiment. That is, the electric vibration energy Er transmitted from the secondary side to the tertiary side after the generation of the pulse wave is rapidly accumulated by the capacitor C1 included in the consumption circuit 13A. Therefore, in the first modification, the attenuation efficiency of the ringing wave can be further improved as compared with the fifth embodiment. In addition, the consumption circuit 13A is connected to the tertiary winding Lc, and is electrically insulated from the pulse generation circuit 9. Therefore, since the ground can be installed at any place in the tertiary winding Lc including the consumption circuit 13A, the operation of the consumption circuit 13A can be further stabilized. Accordingly, the occurrence of the malfunction in the pulse power supply device 3E can be more reliably prevented.

In a pulse power supply device 3F according to the second modification illustrated in FIG. 23, the consumption circuit 13B is connected to the tertiary winding Lc of the transformer 7D. Similarly to the third embodiment, the consumption circuit 13B further includes the converter 25 in addition to the resistor R1, the capacitor C1, and the switching element SW5. The operation of a dielectric barrier discharge device 1F including the pulse power supply device 3F according to the second modification is common to that of the third embodiment. That is, the combination of the on/off states of the switching elements SW1 to SW5 in the second modification is as illustrated in FIGS. 9 and 10, and States 1 to 6 are repeated with the six states as one cycle.

In the second modification, by applying the configuration such as the transformer 7D according to the fifth embodiment to the configuration of the third embodiment, it is possible to obtain the effects of the third embodiment and the effects of the fifth embodiment. That is, the electric vibration energy Er transmitted from the secondary side to the tertiary side after the generation of the pulse wave is rapidly accumulated by the capacitor C1 included in the consumption circuit 13B. Therefore, in the first modification, the attenuation efficiency of the ringing wave can be further improved as compared with the fifth embodiment. In addition, when the converter 25 is provided, the electric vibration energy Er accumulated in the capacitor C1 can be regenerated and reused, so that the energy efficiency of the pulse power supply device 3F can be improved. Then, the consumption circuit 13B is connected to the tertiary winding Lc, and is electrically insulated from the pulse generation circuit **9.** Therefore, since the ground can be installed at any place in the tertiary winding Lc including the consumption circuit 13B, the operation of the consumption circuit 13B can be further stabilized. Accordingly, the occurrence of the malfunction in the pulse power supply device 3F can be more reliably prevented.

In a pulse power supply device 3G according to a third modification illustrated in FIG. 24, the consumption circuit 13C is connected to the tertiary winding Lc of the transformer 7D. Similarly to the fourth embodiment, the consumption circuit 13C includes two sets of the consumption circuits 13A, that is, the consumption circuit 13Ap and the consumption circuit 13As. The consumption circuit 13Ap includes the resistor R1 and the capacitor C1 connected in series, and the switching element SW5 connected in parallel to each of the resistor R1 and the capacitor C1. The consumption circuit 13As includes the resistor R2 and the capacitor C2 connected in series, and the switching element SW6 connected in parallel to each of the resistor R2 and the capacitor C2.

The operation of a dielectric barrier discharge device 1G including the pulse power supply device 3G according to the third modification is common to that of the fourth embodiment. That is, the combination of the on/off states of the switching elements SW1 to SW6 in the third modification is as illustrated in FIGS. 16 and 17, and States 1 to 6 are repeated with the six states as one cycle.

In the third modification, by applying the configuration such as the transformer 7D according to the fifth embodiment to the configuration of the fourth embodiment, it is possible to obtain the effects of the fourth embodiment and the effects of the fifth embodiment. That is, the plurality of consumption circuits 13A included in the consumption circuit 13C is selectively used according to the pulse wave generation conditions or the like. As an example, by alternating the consumption circuit 13A used to consume the electric vibration energy Er every time the pulse wave is generated, it is possible to process the larger electric vibration energy Er. Then, the consumption circuit 13C is connected to the tertiary winding Lc, and is electrically insulated from the pulse generation circuit 9. Therefore, since the ground can be installed at any place in the tertiary winding Lc including the consumption circuit 13C, the operation of the consumption circuit 13C can be further stabilized. Accordingly, the occurrence of the malfunction in the pulse power supply device 3G can be more reliably prevented.

(2) In each of the above-described embodiments and modifications, the pulse generation circuit 9 is not limited to the four-switch circuit as illustrated in FIG. 1, and other circuits such as a one-switch circuit or a two-switch circuit may be appropriately used as long as the circuit generates a pulse wave. In addition, the pulse generation circuit 9 is not limited to a circuit that generates the positive pulse wave Px and the negative pulse wave Py having opposite polarities, and may be a circuit that continues to generate pulse waves having the same polarity, as an example.

FIG. 25(a) illustrates a pulse power supply device 3H including a pulse generation circuit 9H which is a one-switch circuit as a modification of the pulse power supply device 3D according to the fifth embodiment. In the fourth modification, the pulse power supply device 3H and the discharger 5 are included in a dielectric barrier discharge device 1H. The pulse power supply device 3H according to the fourth modification includes the transformer 7D and the pulse generation circuit 9H. Similarly to the fifth embodiment, the transformer 7D includes the primary winding La, the secondary winding Lb, and the tertiary winding Lc. The pulse generation circuit 9H is connected to the primary winding La, and the consumption circuit 13 is connected to the tertiary winding Lc.

The pulse generation circuit 9H includes the power supply 11 and one switching element SW1. The power supply 11, the switching element SW1, and the primary winding La are connected in series. Similarly to the first embodiment and the fifth embodiment, the consumption circuit 13 has a configuration in which the resistor R1 and the switching element SW5 are connected in series.

Here, the operation of the dielectric barrier discharge device 1H will be described. In the dielectric barrier discharge device 1H according to the fourth modification, as illustrated in FIGS. 25(b) and 25(c), regarding the combination of the on/off states of the switching element SW1 and the switching element SW5, State 1 and State 2 are repeated with the two states as one cycle.

Note that, similarly to the first embodiment and the like, the dead times DT1 and DT2 are provided so that the switching element SW1 and the switching element SW5 are not simultaneously turned on. That is, at the timing when the dead time DT1 elapses after the switching element SW5 is switched to an off-state, the switching element SW1 is switched to an on-state and State 1 is started. Then, at the timing when the dead time DT2 elapses after the switching element SW1 is switched to an off-state and State 1 ends, the switching element SW5 is switched from an off-state to an on-state and State 2 is started.

First, State 1 in the fourth modification will be described. In State 1, control is performed by the switch controller 21 so that the switching element SW1 provided in the pulse generation circuit 9H is switched to an on-state, while the switching element SW5 provided in the consumption circuit 13 is switched to an off-state.

When the switching elements SW1 and SW5 are switched according to the combination mode of State 1, the primary winding La and the pulse generation circuit 9H are electrically connected. Then, power is supplied from the power supply 11 to the pulse generation circuit 9H, positive pulse voltage by the positive pulse wave Px is applied from the primary winding La to the secondary winding Lb, and the dielectric barrier discharge occurs in the parallel plate electrode 17. That is, as illustrated in FIG. 26, the positive pulse wave Px is generated in State 1. When the positive pulse wave Px is generated in State 1, electric vibration is generated. Therefore, the state transitions to State 2, and the ringing wave Kx due to the electric vibration is attenuated.

In State 2 in the fourth modification, control is performed by the switch controller 21 so that the switching element SW1 provided in the pulse generation circuit 9H is switched to an off-state, while the switching element SW5 provided in the consumption circuit 13 is switched to an on-state.

When the switching elements SW1 and SW5 are switched according to the combination mode of State 2, the tertiary winding Lc and the consumption circuit 13 are electrically connected. Then, the electric vibration energy Er flows from the secondary winding Lb of the transformer 7D to the consumption circuit 13 via the tertiary winding Lc, and the electric vibration energy Er is quickly consumed in the resistor R1 provided in the consumption circuit 13. When the electric vibration energy Er is consumed in the resistor R1, as illustrated in FIG. 26, the ringing wave Kx occurring after the positive pulse wave Px is oscillated in State 1 is rapidly attenuated by the operation in State 2. Accordingly, the ringing period Rx after the pulse wave Px is oscillated in State 1 is significantly shortened.

The operation in State 2 is completed, so that a series of operations with States 1 to 2 as one cycle is completed. Thereafter, the state returns to State 1 from State 2, and a series of operations including States 1 to 2 is appropriately repeated to execute plasma processing by the dielectric barrier discharge. As described above, in the fourth modification including the pulse generation circuit 9H which is a one-switch circuit, only the positive pulse wave Px is continuously oscillated.

Next, a modification including the two-switch circuit will be described. FIG. 27 illustrates a pulse power supply device 3J including a pulse generation circuit 9J which is the two-switch circuit as a modification of the pulse power supply device 3D according to the fifth embodiment. In the fifth modification, the pulse power supply device 3J and the discharger 5 are included in a dielectric barrier discharge device 1J. The pulse power supply device 3J according to the fifth modification includes the transformer 7D and the pulse generation circuit 9J. Similarly to the fifth embodiment, the transformer 7D includes the primary winding La, the secondary winding Lb, and the tertiary winding Lc. The pulse generation circuit 9J is connected to the primary winding La, and the consumption circuit 13 is connected to the tertiary winding Lc.

In the pulse generation circuit 9J, the first circuit in which the first switching element SW1 and the second switching element SW2 are connected in series and the second circuit in which a capacitor C3 and a capacitor C4 are connected in series are inserted in parallel to each other between a positive terminal and a negative terminal of the power supply 11. Then, the primary winding La is inserted between the connection point T1 of the switching element SW1 and the switching element SW2 and the connection point T2 of the capacitor C3 and the capacitor C4. Similarly to the first embodiment and the fifth embodiment, the consumption circuit 13 has a configuration in which the resistor R1 and the switching element SW5 are connected in series.

Each of the capacitor C3 and the capacitor C4 is configured to be equivalent to a voltage source. That is, half of the voltage of the power supply 11 is applied to each of the capacitor C3 and the capacitor C4. In a case where the switching element SW1 is on, the capacitor C3 is used as a voltage source. In addition, in a case where the switching element SW2 is on, the capacitor C4 is used as a voltage source.

Here, the operation of the dielectric barrier discharge device 1J will be described. In the dielectric barrier discharge device 1J according to the fifth modification, as illustrated in FIGS. 28 and 29, regarding the combination of the on/off states of the switching element SW1 and the switching element SW5, States 1 to 4 are repeated with the four states as one cycle.

In State 1 in the fifth modification, the switching elements SW2 and SW5 are switched off, while the switching element SW1 is switched on. Specifically, at the timing when the dead time DT1 elapses after the switching elements SW2 and SW5 are switched to an off-state, the switching element SW1 is switched to an on-state, and State 1 is started.

When State 1 is started, power is supplied from the power supply 11 to the pulse generation circuit 9J, and the current flows via the switching element SW1. As a result, the positive pulse voltage by the pulse wave Px is applied from the primary winding La to the secondary winding Lb, and the plasma Pr is generated in the parallel plate electrode 17. Due to the discharge, the ringing wave Kx due to electric vibration occurs. Therefore, when State 1 in which the positive pulse wave Px is generated is completed, the state transitions to State 2, and the operation of attenuating the ringing wave Kx is performed.

In State 2 in the fifth modification, the switching elements SW1 and SW2 of the pulse generation circuit 9J are switched off, while the switching element SW5 of the consumption circuit 13 is switched on. Specifically, at the timing when the dead time DT2 elapses after the switching element SW1 is switched to an off-state and State 1 ends, the switching element SW5 is switched from an off-state to an on-state, and State 2 is started.

When the switching elements SW1, SW2, and SW5 are switched according to the combination mode of State 2, the tertiary winding Lc and the consumption circuit 13 are electrically connected. Then, the electric vibration energy Er flows from the secondary winding Lb of the transformer 7D to the consumption circuit 13 via the tertiary winding Lc, and the electric vibration energy Er is quickly consumed in the resistor R1 provided in the consumption circuit 13. When the electric vibration energy Er is consumed in the resistor R1, the ringing wave Kx generated after the positive pulse wave Px is oscillated in State 1 is rapidly attenuated by the operation in State 2. Accordingly, the ringing period Rx after the pulse wave Px is oscillated in State 1 is significantly shortened. When the ringing wave Kx is attenuated and disappears, the state transitions from State 2 to State 3 to generate the negative pulse wave Py.

In State 3 in the fifth modification, the switching elements SW1 and SW5 are switched off, while the switching element SW2 is switched on. Specifically, at the timing when the dead time DT3 elapses after the switching elements SW1 and SW5 are switched to an off-state, the switching element SW2 is switched to an on-state, and State 3 is started.

When State 3 is started, power is supplied from the power supply 11 to the pulse generation circuit 9J, and the current in a direction opposite to State 1 flows via the switching element SW2. As a result, the positive pulse voltage due to the pulse wave Py is applied from the primary winding La to the secondary winding Lb, and the plasma Pr is generated in the parallel plate electrode 17. Due to the discharge, the ringing wave Ky due to electric vibration occurs. Therefore, when State 1 in which the negative pulse wave Py is generated is completed, the state transitions to State 2, and the operation of attenuating the ringing wave Ky is performed.

In State 4 in the fifth modification, similarly to State 2, the switching elements SW1 and SW2 of the pulse generation circuit 9J are switched off, while the switching element SW5 of the consumption circuit 13 is switched on. Specifically, at the timing when the dead time DT4 elapses after the switching element SW2 is switched to an off-state and State 3 ends, the switching element SW5 is switched from an off-state to an on-state, and State 4 is started.

When State 4 is started, the tertiary winding Lc and the consumption circuit 13 are electrically connected again. Then, the electric vibration energy Er flows to the consumption circuit 13, and the electric vibration energy Er is quickly consumed in the resistor R1 provided in the consumption circuit 13. When the electric vibration energy Er is consumed in the resistor R1, the ringing wave Ky occurring after the negative pulse wave Py is oscillated in State 3 is rapidly attenuated by the operation in State 4.

The operation in State 4 is completed, so that a series of operations with States 1 to 4 as one cycle is completed. Thereafter, the state returns to State 1 from State 4, and a series of operations including States 1 to 4 is appropriately repeated to execute plasma processing by the dielectric barrier discharge.

As described above, the pulse generation circuit 9 is not limited to the four-switch circuit, and even when a one-switch circuit or a two-switch circuit is used, it is possible to realize the pulse power supply device 3 that can quickly consume the ringing and increase the frequency of the pulse. That is, in the pulse power supply device 3 according to each embodiment, after the pulse generation circuit 9 is operated to generate a pulse wave, the consumption circuit 13 is operated to consume the electric vibration energy Er and perform the control to attenuate the electric vibration, so that the ringing occurring after the generation of the pulse wave can be quickly consumed.

(3) Although the dielectric barrier discharge device 1 in which the pulse power supply device 3 and the discharger 5 are combined has been described as an example in each of the above-described embodiments and modifications, the pulse power supply device 3 according to each of the embodiments and the like can also be applied to other devices exemplifying an induction heating device. Here, as illustrated in FIG. 30, an induction heating device 31 including the pulse power supply device 3 according to the first embodiment will be described as an example.

The induction heating device 31 includes the pulse power supply device 3 according to the first embodiment and an induction heater 33. The induction heater 33 is connected to the secondary winding Lb of the transformer 7, and includes a heating coil 35 corresponding to an inductive load. The heating coil 35 is configured to accommodate a conductive object to be heated therein. By applying the pulse voltage output from the pulse power supply device 3 to the heating coil 35, a magnetic field is generated around the heating coil 35, and the conductive object to be heated is heated in a non-contact state with the heating coil 35. The heating coil 35 corresponds to an induction heating unit in the present invention.

The operation of the induction heating device 31 including the pulse power supply device 3 is common to the operation of the dielectric barrier device 1 including the pulse power supply device 3. That is, as illustrated in FIGS. 2 and 3, regarding the combination of the on/off states of the switching element SW1 to the switching element SW5 provided in the pulse power supply device 3, States 1 to 4 are repeated with the four states as one cycle. In State 1, the positive pulse wave Px is generated, and the positive pulse voltage is applied to the heating coil 35 to perform induction heating. The ringing wave Kx generated by the generation of the positive pulse wave Px is quickly attenuated by the electric vibration energy Er consumed by the consumption circuit 13 in State 2.

Thereafter, the negative pulse wave Py is generated in State 3, and the negative pulse voltage is applied to the heating coil 35 to perform induction heating again. The ringing wave Ky generated by the generation of the negative pulse wave Py is quickly attenuated by the electric vibration energy Er consumed by the consumption circuit 13 in State 4. Then, the state returns to State 1 from State 4, and States 1 to 4 are repeated with the four states as one cycle. As described above, the present invention is not limited to the dielectric barrier discharge device 1, and by applying the pulse power supply device 3 to other devices such as the induction heating device 31, it is possible to increase the frequency of the pulse wave while maintaining the waveform of the pulse wave in a desired shape. Therefore, the pulse voltage can be suitably applied, and the output of the pulse voltage can be further improved.

(4) In the fourth embodiment described above, the configuration has been exemplified in which the consumption circuit 13C includes a plurality of the consumption circuits 13A according to the second embodiment, but the present invention is not limited thereto. That is, the consumption circuit 13C may be configured to include a plurality of the consumption circuits 13 according to the first embodiment, or may be configured to include a plurality of the consumption circuits 13B according to the third embodiment.

In addition, in the configuration in which the pulse power supply device 3 includes a plurality of consumption circuits 13, it is preferable that each of the consumption circuits 13 has different suitable frequency of electric vibration. As an example, FIG. 34 illustrates a configuration of a pulse power supply device 3K including two consumption circuits 13 having different characteristics. FIG. 34 illustrates a configuration of a dielectric barrier device 1K including the pulse power supply device 3K according to the sixth modification.

In the pulse power supply device 3K according to the sixth modification, one consumption circuit 13 (consumption circuit 13X) is suitable for the consumption of electric vibration having a relatively high frequency, and the other consumption circuit 13 (consumption circuit 13Y) is suitable for the consumption of electric vibration having a relatively low frequency. The consumption circuit 13X includes a resistor Rx and a switching element SW5x connected in series. The consumption circuit 13Y includes a resistor Ry and a switching element SW5y connected in series. In the pulse power supply device 3K, it is assumed that the resistor Rx is set to a resistance value suitable for the consumption of electric vibration having a relatively high frequency, and the resistor Ry is set to a resistance value suitable for the consumption of electric vibration having a relatively low frequency.

In such a pulse power supply device 3K, a consumption circuit most suitable for the consumption of electric vibration is selected from the plurality of consumption circuits 13 according to a change in a condition using the frequency of the electric vibration as an example, and using the selected consumption circuit 13, the electric vibration energy Er is consumed. That is, the pulse power supply device 3 includes a detector 36 that detects the frequency of the electric vibration, and the main controller 15 further includes a consumption circuit selector 37.

The consumption circuit selector 37 selects a consumption circuit most suitable for consumption of electric vibration from the plurality of the consumption circuits 13, and transmits information of selected consumption circuit 13 to the switch controller 21. By switching the switching element SW5 included in the selected consumption circuit 13 to an on-state, the switch controller 21 causes the consumption circuit 13 selected by the consumption circuit selector to operate to consume the electric vibration energy Er.

As a specific example, in a case where the electric vibration having a relatively high frequency occurs, by detecting the frequency of the electric vibration, the detector 36 transmits information on the frequency to the consumption circuit selector 37. Based on the occurrence of the electric vibration having a relatively high frequency, the consumption circuit selector 37 transmits, to the switch controller 21, information indicating that the one consumption circuit 13X is selected. In State 2 or the like, the switch controller 21 performs control to switch the switching element SW5x provided in the consumption circuit 13X among the consumption circuit 13X and the consumption circuit 13Y to on. Under the control of the switch controller 21, the electric vibration energy Er flows to the consumption circuit 13X among the consumption circuit 13X and the consumption circuit 13Y, and is suitably consumed by the resistor Rx suitable for the electric vibration having a relatively high-frequency.

When the plurality of consumption circuits 13 is provided as described above, it is possible to realize the pulse power supply device 3 capable of suitably coping with electric vibrations having various frequencies. Therefore, even when the frequency of the electric vibration changes, the ringing wave can be attenuated by selectively using the consumption circuit 13 corresponding to the impedance related to the changed frequency.

### Reference Signs List

- 1: dielectric barrier discharge device
- 3: pulse power supply device
- 5: discharger (dielectric barrier discharge unit)
- 7: transformer
- 9: pulse generation circuit
- 11: power source
- 13: consumption circuit (electric vibration consumption circuit)
- 15: main controller
- 17: parallel plate electrode
- 17a: first electrode
- 17b: second electrode
- 19: dielectric
- 21: switch controller
- 23: consumption time controller
- 25: converter
- 31: induction heating device
- 33: induction heater
- 35: heating coil
- 36: detector
- 37: consumption circuit selector
- R1: resistor
- C1: capacitor
- D1: diode
- SW1 to SW4: switching element (pulse wave generation switching element)
- SW5 to SW6: switching element (resistance switching element)
- La: primary winding
- Lb: secondary winding
- Lc: tertiary winding
- Er: electrical vibration energy

## Claims

1. A pulse power supply device comprising:
a transformer including a primary winding and a secondary winding;
a pulse wave generation circuit connected to the primary winding and including at least one pulse wave generation switching element;
an electric vibration consumption circuit connected in parallel to the pulse wave generation circuit, the electric vibration consumption circuit including a consumption resistor configured to consume energy of electric vibration occurring in the secondary winding and transmitted to the primary winding, and a resistance switching element connected in series to the consumption resistor;
a switch controller configured to switch on/off of the pulse wave generation switching element and the resistance switching element; and
a consumption time controller configured to control timing at and a period during which the resistance switching element is switched to an on-state.

2. The pulse power supply device according to claim 1, wherein
the electric vibration consumption circuit further includes:
a capacitor configured to accumulate energy of the electric vibration, and
each of the capacitor and the consumption resistor connected in parallel to each other is connected in series to the resistance switching element.

3. The pulse power supply device according to claim 1, wherein
the electric vibration consumption circuit further includes:
a capacitor configured to accumulate energy of the electric vibration; and
an energy regeneration unit configured to regenerate energy of the electric vibration accumulated in the capacitor; and
a regenerative circuit having a configuration in which the capacitor and the energy regeneration unit are connected in parallel and the consumption resistor are connected in parallel, and each of the consumption resistor and the regenerative circuit is connected in series to the resistance switching element.

4. The pulse power supply device according to claim 1, wherein
the pulse wave generation circuit is
an H-bridge circuit in which the four pulse wave generation switching elements SW1, SW2, SW3, and SW4 are H-bridge-connected, and
the switch controller sequentially and repeatedly performs switching control in four on/off combination modes of States 1 to 4 illustrated in the following Table 1 for each of the four pulse wave generation switching elements SW1, SW2, SW3, and SW4 and the resistance switching element SW5.
**[Table 1]**
| | STATE 1 | STATE 2 | STATE 3 | STATE 4 |
|---|---|---|---|---|
| SW1 | ON | OFF | OFF | OFF |
| SW2 | OFF | OFF | ON | OFF |
| SW3 | OFF | OFF | ON | OFF |
| SW4 | ON | OFF | OFF | OFF |
| SW5 | OFF | ON | OFF | ON |

5. The pulse power supply device according to claim 2, wherein
the pulse wave generation circuit is
a H-bridge circuit in which the four pulse wave generation switching elements SW1, SW2, SW3, and SW4 are H-bridge-connected,
the electric vibration consumption circuit has two sets of a configuration in which each of the capacitor and the consumption resistor connected in parallel to each other is connected in series to the resistance switching element, and
the switch controller sequentially and repeatedly performs switching control on each of the four pulse wave generation switching elements SW1, SW2, SW3, and SW4 and the two resistance switching elements SW5 and SW6 in six on/off combination modes of States 1 to 6 illustrated in the following Table 2.
**[Table 2]**
| | STATE 1 | STATE 2 | STATE 3 | STATE 4 | STATE 5 | STATE 6 |
|---|---|---|---|---|---|---|
| SW1 | ON | OFF | OFF | OFF | OFF | OFF |
| SW2 | OFF | OFF | OFF | ON | OFF | OFF |
| SW3 | OFF | OFF | OFF | ON | OFF | OFF |
| SW4 | ON | OFF | OFF | OFF | OFF | OFF |
| SW5 | OFF | ON | OFF | OFF | OFF | OFF |
| SW6 | OFF | OFF | OFF | OFF | ON | OFF |

6. A pulse power supply device comprising:
a transformer including a primary winding, a secondary winding, and a tertiary winding insulated from one another;
a pulse wave generation circuit connected to the primary winding and including at least one pulse wave generation switching element;
an electric vibration consumption circuit connected to the tertiary winding, the electric vibration consumption circuit including a consumption resistor configured to consume energy of electric vibration occurring in the secondary winding and transmitted to the tertiary winding, and a resistance switching element connected in series to the consumption resistor;
a switch controller configured to switch on/off of the pulse wave generation switching element and the resistance switching element; and
a consumption time controller configured to control timing at and a period during which the resistance switching element is switched to an on-state.

7. The pulse power supply device according to claim 6, wherein
the electric vibration consumption circuit further includes:
a capacitor configured to accumulate energy of the electric vibration, and
each of the capacitor and the consumption resistor connected in parallel to each other is connected in series to the resistance switching element.

8. The pulse power supply device according to claim 6, wherein
the electric vibration consumption circuit further includes:
a capacitor configured to accumulate energy of the electric vibration; and
an energy regeneration unit configured to regenerate energy of the electric vibration accumulated in the capacitor, and
a regenerative circuit having a configuration in which the capacitor and the energy regeneration unit are connected in parallel and the consumption resistor are connected in parallel, and each of the consumption resistor and the regenerative circuit is connected in series to the resistance switching element.

9. The pulse power supply device according to claim 6, wherein
the pulse wave generation circuit is
an H-bridge circuit in which the four pulse wave generation switching elements SW1, SW2, SW3, and SW4 are H-bridge-connected, and
the switch controller sequentially and repeatedly performs switching control in four on/off combination modes of States 1 to 4 illustrated in the following Table 1 for each of the four pulse wave generation switching elements SW1, SW2, SW3, and SW4 and the resistance switching element SW5.
**[Table 1]**
| | STATE 1 | STATE 2 | STATE 3 | STATE 4 |
|---|---|---|---|---|
| SW1 | ON | OFF | OFF | OFF |
| SW2 | OFF | OFF | ON | OFF |
| SW3 | OFF | OFF | ON | OFF |
| SW4 | ON | OFF | OFF | OFF |
| SW5 | OFF | ON | OFF | ON |

10. The pulse power supply device according to claim 7, wherein
the pulse wave generation circuit is
an H-bridge circuit in which the four pulse wave generation switching elements SW1, SW2, SW3, and SW4 are H-bridge-connected,
the electric vibration consumption circuit has
two sets of configurations in which each of the capacitor and the consumption resistor connected in parallel to each other is connected in series to the resistance switching element, and
the switch controller sequentially and repeatedly performs switching control on each of the four pulse wave generation switching elements SW1, SW2, SW3, and SW4 and the two resistance switching elements SW5 and SW6 in six on/off combination modes of States 1 to 6 illustrated in the following Table 2.
**[Table 2]**
| | STATE 1 | STATE 2 | STATE 3 | STATE 4 | STATE 5 | STATE 6 |
|---|---|---|---|---|---|---|
| SW1 | ON | OFF | OFF | OFF | OFF | OFF |
| SW2 | OFF | OFF | OFF | ON | OFF | OFF |
| SW3 | OFF | OFF | OFF | ON | OFF | OFF |
| SW4 | ON | OFF | OFF | OFF | OFF | OFF |
| SW5 | OFF | ON | OFF | OFF | OFF | OFF |
| SW6 | OFF | OFF | OFF | OFF | ON | OFF |

11. A dielectric barrier discharge device, comprising:
the pulse power supply device according to any one of claims 1 to 10; and
a dielectric barrier discharge unit connected to the secondary winding as a load circuit of the pulse power supply device.

12. An induction heating device comprising:
the pulse power supply device according to any one of claims 1 to 10; and
an induction heating unit connected to the secondary winding as a load circuit of the pulse power supply device.
